# EUROPÄISCHE PATENTSCHRIFT

(11) **EP 3 440 690 B1**
(45) Veröffentlichungstag und Bekanntmachung des Hinweises auf die Patenterteilung: **11.08.2021**
(21) Anmeldenummer: 17717106.3
(22) Anmeldetag: 04.04.2017
(51) Int. Cl.: H01J 37/317

(54) **ENERGIEFILTERELEMENT FÜR IONENIMPLANTATIONSANLAGEN FÜR DEN EINSATZ IN DER PRODUKTION VON WAFERN**
ENERGY FILTER ELEMENT FOR ION IMPLANTATION SYSTEMS FOR THE USE IN THE PRODUCTION OF WAFERS
ÉLÉMENT DE FILTRE D'ÉNERGIE POUR INSTALLATIONS D'IMPLANTATION IONIQUE DESTINÉES À ÊTRE UTILISÉES DANS LA PRODUCTION DE TRANCHES

(30) Priorität: 04.04.2016 DE 102016106119
(43) Veröffentlichungstag der Anmeldung: 13.02.2019
(60) Teilanmeldung: 21183792.7
(73) Patentinhaber: mi2-factory GmbH, 07745 Jena (DE)
(72) Erfinder: KRIPPENDORF, Florian, 07743 Jena (DE); CSATO, Constantin, 95236 Stammbach (DE)
(74) Vertreter: Wächter, Jochen
(86) Internationale Anmeldenummer: PCT/EP2017/058018
(87) Internationale Veröffentlichungsnummer: WO 2017/174597

(56) Entgegenhaltungen:
- EP-A1- 0 014 516
- DE-A1-102005 061 663
- DE-A1-102011 075 350
- US-A- 5 972 728
- KRIPPENDORF F. ET AL.: "Dotierung von SiC mittels Energiefilter für Ioninmplantation/Doping of SiC by means of Energy Filter for Ion Implantation" In: VDI-Gesellschaft Mikroelektronik, Mikrosystemtechnik und Feinwerktechnik (Hrsg.): "Mikrosystemtechnik Kongress 2015 "MEMS, Mikroelektronik, Systeme" 26.-28. Oktober 2015 Karlsruhe", 26. Oktober 2015 (2015-10-26), VDE VERLAG, Berlin - Offenbach, XP009194563, ISBN: 978-3-8007-4100-7 Seiten 334-337, Legende zu Figur 1; Abbildung 1 Abschnitt 4 "Experiment"; Abbildung 4 & Anonymous: "buchhandel.de", , 2. Juni 2017 (2017-06-02), XP055378536, Gefunden im Internet: URL:https://www.buchhandel.de/buch/9783800 741007?MVB-Kennnummer=83426 [gefunden am 2017-06-02]
- KRIPPENDORF F ET AL: "Energiefilter fuer Ionenimplantation / Energy filter for ion implantation", VON BAUELEMENTEN ZU SYSTEMEN : MIKROSYSTEMTECHNIK KONGRESS 2013, 14. - 16. OKTOBER 2013 IN AACHEN : PROCEEDINGS, VDE-VERL, BERLIN [U.A.], 14. Oktober 2013 (2013-10-14), Seiten 662-665, XP009194724, ISBN: 978-3-8007-3555-6
- CSATO CONSTANTIN ET AL: "Energy filter for tailoring depth profiles in semiconductor doping application", NUCLEAR INSTRUMENTS & METHODS IN PHYSICS RESEARCH. SECTION B: BEAM INTERACTIONS WITH MATERIALS AND ATOMS, Bd. 365, 31. Juli 2015 (2015-07-31), Seiten 182-186, XP029313812, ISSN: 0168-583X, DOI: 10.1016/J.NIMB.2015.07.102
- RUB M ET AL: "550 V superjunction 3.9 /spl Omega/mm<2> transistor formed by 25 MeV masked boron implantation", POWER SEMICONDUCTOR DEVICES AND ICS, 2004. PROCEEDINGS. ISPSD '04. THE 16TH INTERNATIONAL SYMPOSIUM ON KITAKYUSHU INT. CONF. CTR, JAPAN MAY 24-27, 2004, PISCATAWAY, NJ, USA,IEEE, 24. Mai 2004 (2004-05-24), Seiten 455-458, XP010723449, ISBN: 978-4-88686-060-6
- CSATO CONSTANTIN ET AL: "Energy filter for tailoring depth profiles in semiconductor doping application", NUCLEAR INSTRUMENTS & METHODS IN PHYSICS RESEARCH. SECTION B: BEAM INTERACTIONS WITH MATERIALS AND ATOMS, vol. 365, 31 July 2011 (2011-07-31), pages 182-186, XP029313812, ISSN: 0168-583X, DOI: 10.1016/J.NIMB.2015.07.102

## Beschreibung

Die Erfindung betrifft eine Implantationsanordnung mit einem Energiefilter (Implantationsfilter) für eine Ionenimplantation und dessen Verwendung und ein Implantationsverfahren.

Mittels Ionenimplantation kann eine Dotierung bzw. die Erzeugung von Defektprofilen in beliebigen Materialien, wie etwa Halbleitern (Silizium, Siliziumcarbid, Galliumnitrid) oder optischen Materialien (LiNbO3), mit vordefinierten Tiefenprofilen im Tiefenbereich von wenigen Nanometern bis hin zu einigen 100 Mikrometern erreicht werden. Wünschenswert ist es dabei insbesondere Tiefenprofile zu erzeugen, die durch eine größere Tiefenverteilungsbreite charakterisiert sind als die Breite eines durch einen monoenergetischen Ionenstrahlung erzeugbaren Dotierkonzentrationspeaks oder Defektkonzentrationspeaks, oder Dotier- oder Defekttiefenprofile zu erzeugen, welche durch eine oder einige wenige einfache monoenergetische Implantationen nicht erzeugt werden können.

### KURZBESCHREIBUNG DER FIGUREN

Figur 1 veranschaulicht das Grundprinzip eines Energiefilter: Ein monoenergetischer Ionenstrahl wird beim Durchtritt durch eine mikrostrukturierte Energiefilterkomponente abhängig vom Eintrittsort in seiner Energie modifiziert. Die resultierende Energieverteilung der Ionen führt zu einer Modifikation des Tiefenprofils des implantierten Stoffes in einer Substratmatrix.
Figur 2 zeigt links ein Waferrad auf welchem zu implantierende Substrate fixiert werden. Bei der Prozessierung/Implantation wird das Rad um 90° nach gekippt und in Rotation versetzt. Das Rad wird somit in konzentrischen Kreisen durch den in grün angedeuteten Ionenstrahl mit Ionen "beschrieben". Um die gesamte Waferfläche zu bestrahlen, wird das Rad während der Prozessierung vertikal bewegt. Rechts zeigt Figur 2 ein montiertes Energiefilter im Bereich des Strahlaustritts.

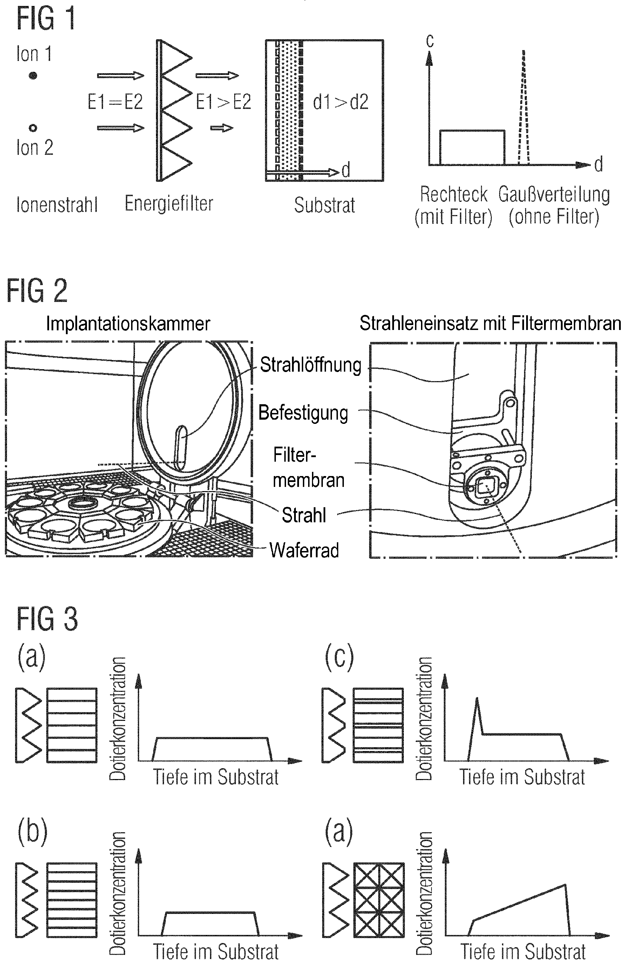

Figur 3 zeigt eine schematische Darstellung verschiedener Dotierprofile (Dotierkonzentration als Funktion der Tiefe im Substrat) für unterschiedlich geformte Energiefiltermikrostrukturen (jeweils in Seitenansicht und Aufsicht dargestellt). (a) Dreiecksprismenförmige Strukturen erzeugen ein rechteckförmiges Dotierprofil. (b) Kleinere dreiecksprismenförmige Strukturen erzeugen ein weniger tiefenverteiltes Dotierprofil. (c) Trapezprismenförmige Strukturen erzeugen ein rechteckförmiges Dotierprofil mit einem Peak am Profilbeginn. (d) Pyramidenförmige Strukturen erzeugen ein dreiecksförmiges, in die Tiefe des Substrates ansteigendes Dotierprofil
Figur 4 zeigt einen Querschnitt eines Filterrahmens zur Aufnahme eines Energiefilterchips
Figur 5 zeigt eine Draufsicht auf einen Filterrahmen zur Aufnahme eines Energiefilterelements mit Verschlusselement und montiertem Energiefilter
Figur 6 veranschaulicht einen typischen Einbau eines Rahmens zur Aufnahme einer Energiefilterelements in den Strahlengang eines Ionenimplanters. In dem Beispiel ist der Filterhalter an einer Seite der Kammerwand angeordnet. In dem Beispiel ist diese Seite die Innenseite der Kammerwand, also die Seite, die bei der Implantation dem Wafer (nicht dargestellt) zugewandt ist. Der in den Filterhalter eingeschobene Rahmen mit dem Filterchip überdeckt die Öffnung der Kammerwand, durch die währen der Implantation der Ionenstrahl tritt.
Figur 7 zeigt einen Teilrahmen (links in der Abbildung) und Vollrahmen (ganz rechts in der Abbildung), die jeweils aus dem gleichen (z.B. monolithisch) und/oder aus einem anderen Material als der Energiefilter bestehen können.
Figur 8 veranschaulicht eine Befestigung des Filterrahmens mit Filter oder jeglichen anderen passiven Streuelements durch einen oder mehrere Stege.
Figur 9 veranschaulicht eine Befestigung des Filterrahmens mit Filter oder jeglichen anderen Streuelements durch eine einfache oder mehrfache Aufhängung.
Figur 10 veranschaulicht eine Befestigung des Filterrahmens mit Filter oder jeglichen anderen Streuelements durch Magnetfelder.

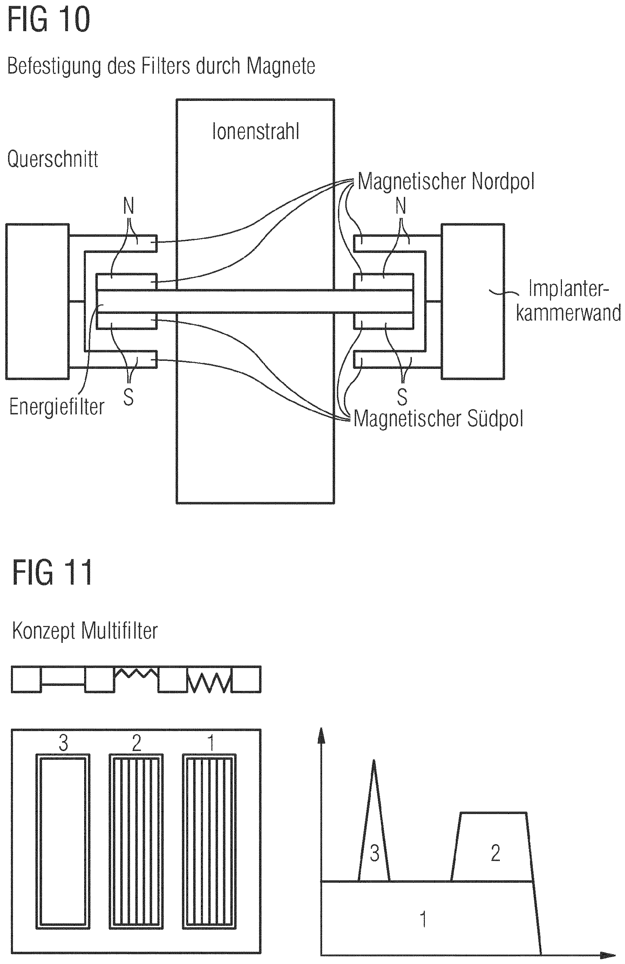

Figur 11 veranschaulicht eine einfache Realisierung eines Multifilters. Drei unterschiedlich ausgeformte Filterelemente sind in einem Rahmen zur Filterhalterung zu einem ganzen Energiefilter zusammengefasst. Der Ionenstrahl überstreicht alle Einzelfilterelemente gleichmäßig. Im vorliegenden Beispiel (links) entsteht somit das rechts dargestellte Dotierstofftiefenprofil. Dieses Profil enthält drei Teilprofile, die mit 1, 2 und 3 nummeriert sind. Jedes dieser Teilprofile resultiert aus einem der drei links dargestellten Teilfilter, und zwar aus dem mit der entsprechenden Nummer versehenen Teilfilter.
Figur 12 veranschaulicht eine detaillierte Darstellung des Multifilterkonzeptes. Links sind drei Filterelemente exemplarisch dargestellt. Vier Elemente sind zahlenmäßig beschrieben. Aus jedem Filterelement resultiert bei gegebener Ionensorte und Primärenergie ein Dotierstofftiefenprofil. Die Wichtung, d.h. die resultierende Konzentration ist durch die Dimensionierung der Flächen der einzelnen Filterelemente justierbar. Für das Beispiel wurde angenommen, dass Filter und Substrat das gleiche energieabhängige Abbremsvermögen besitzen. Im allgemeinen ist dies jedoch nicht der Fall.
Figur 13 zeigt ein Summenprofil, das sich ergibt, wenn alle in Figur 12 beschriebenen Filterelemente mit geeigneter Wichtung zu einem Gesamtfilter zusammenmontiert und gleichmäßig von einem Ionenstrahl geeigneter Primärenergie überstrichen werden.
Figur 14 zeigt eine beispielhafte Anordnung von Einzelfilterelementen in einem Multifilter. Die dort dargestellten Einzelelemente Fl, F2, F3 etc. sind schräg angesägt und werden direkt aufeinander montiert.
Figur 15 zeigt eine Filteranordnung die in eine Ionenimplantationsanlage eingebaut ist. In den Filterhalter, welcher den Filterrahmen aufnimmt, sind Kühlleitungen integriert, welche durch ein externes Kühlgerät mit Kühlflüssigkeit versorgt werden. Die Kühlleitungen könnten auch auf der Oberfläche des Filterhalters angeordnet sein (nicht dargestellt).
Figur 16 zeigt ein Energiefilter mit großer Fläche, welches pro Zeiteinheit nur partiell bestrahlt wird. Somit können die nicht bestrahlten Bereiche über Strahlungskühlung abkühlen.
Diese Ausführungsform ist auch als Multifilter gestaltbar, wie es oben beschrieben wurde. D.h. als Filter, das mehrere unterschiedliche Filterelemente aufweist. In dem dargestellten Beispiel pendelt der Rahmen mit dem Filter in einer Richtung senkrecht zur Strahlrichtung des Ionenstrahls. Die von dem Ionenstrahl überdeckte Fläche des Filters ist geringer als die Gesamtfläche des Filters, so dass pro Zeiteinheit nur ein Teil des Filters durchstrahlt wird. Dieser Teil ändert sich stetig aufgrund der Pendelbewegung.

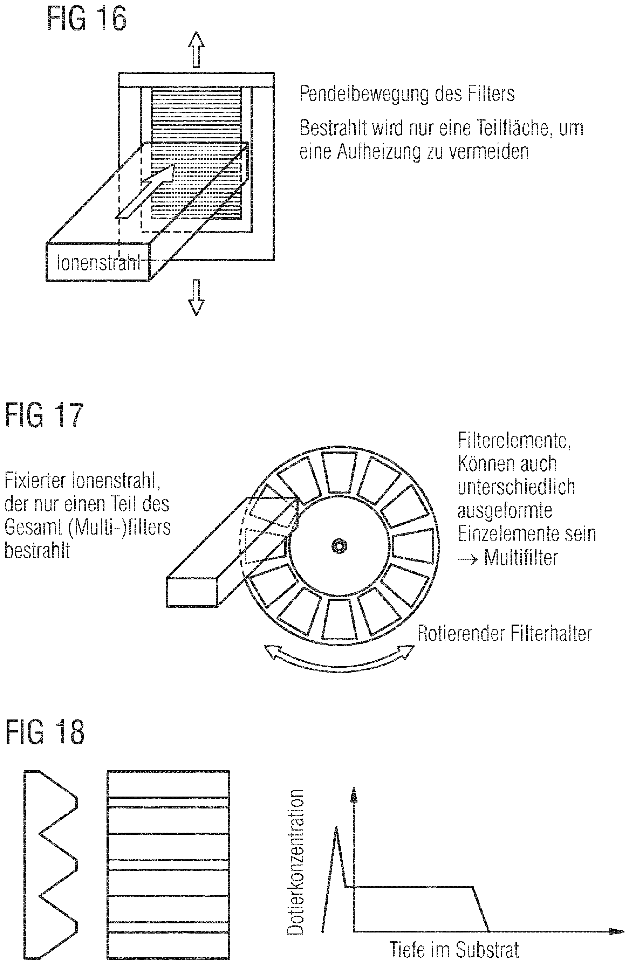

Figur 17 zeigt eine weitere Ausgestaltung einer Anordnung von Energiefiltern, welche um eine zentrale Achse rotieren. Auch wird pro Zeiteinheit nur partiell bestrahlt und die nicht bestrahlten Elemente können abkühlen. Diese Ausführungsform ist auch als Multifilter gestaltbar.
Figur 18 veranschaulicht schematisch eine "Verschiebung des Peaks". Durch Implantation von Ionen in den Energiefilter kann mit Hilfe einer trapezprismenförmigen Struktur ein Rechteckprofil im Substrat erzeugt werden. Der anfängliche Peak wird in den Energiefilter implantiert. Das Implantationsprofil hat die vorteilhafte Eigenschaft, dass es direkt an der Substratoberfläche beginnt, was für die Applikation des Energiefilters von entscheidender Bedeutung ist.

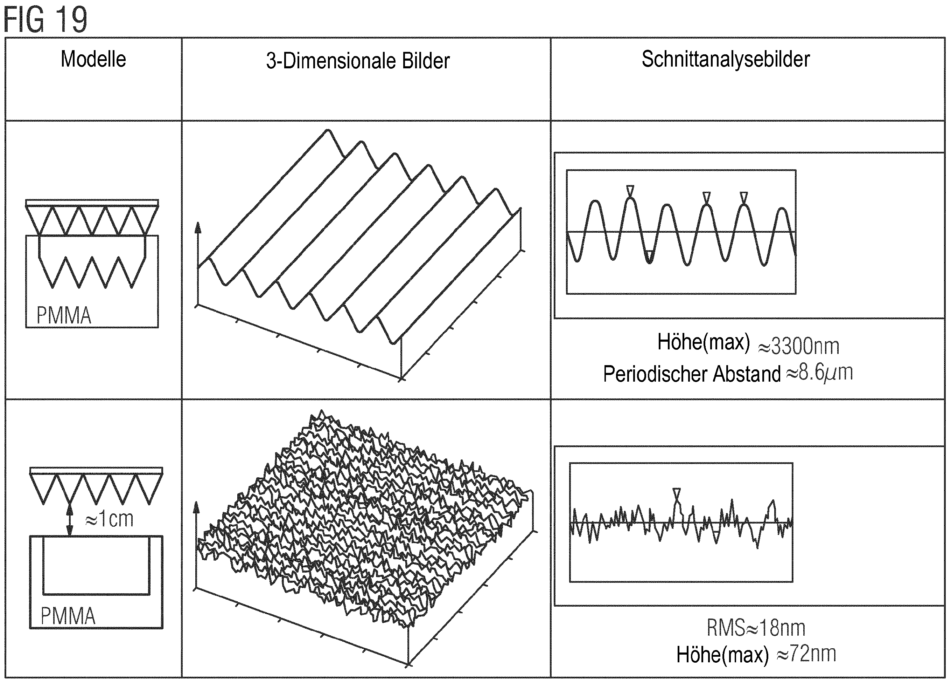

Figur 19 zeigt, wie Ionen durch einen Energiefilter während einer statischen Implantation in ein PMMA Substrat implantiert werden. Die Ionen zerstören hierbei die Molekülstruktur des PMMA. Ein anschließender Entwicklungsprozess, legt die Energieverteilung der Ionen offen. Bereiche hoher Energiedeposition werden herausgelöst. Bereiche geringer oder ohne Energiedeposition durch Ionen werden in der Entwicklerlösung nicht aufgelöst.

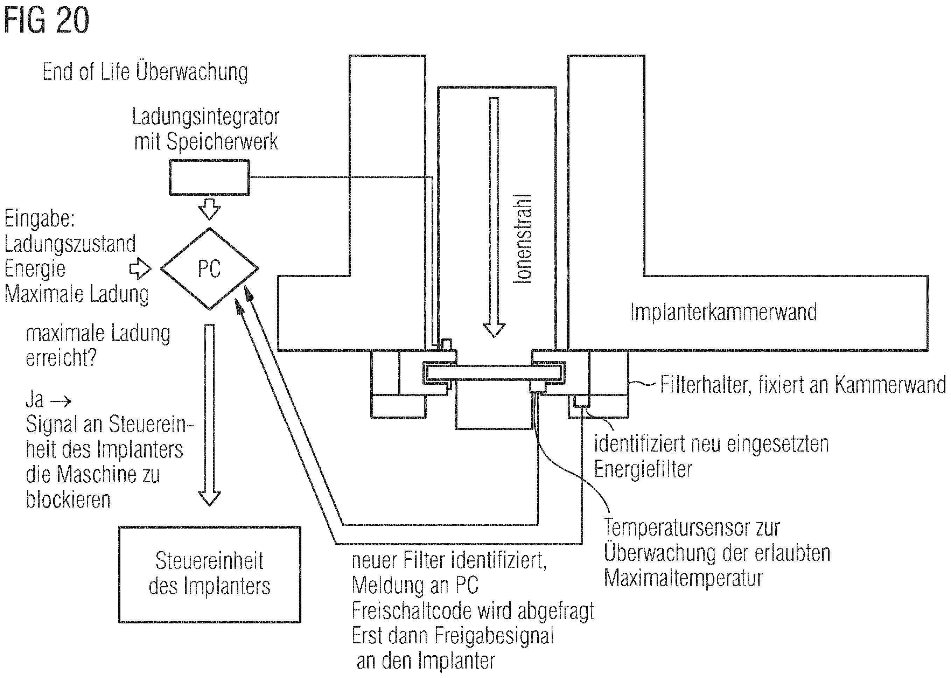

Figur 20 zeigt Kontrollsystem zur Identifikation des Filters und zur Überwachung der Einhaltung der Filterspezifikation (Maximaltemperatur, maximale akkumulierte Ionendosis).

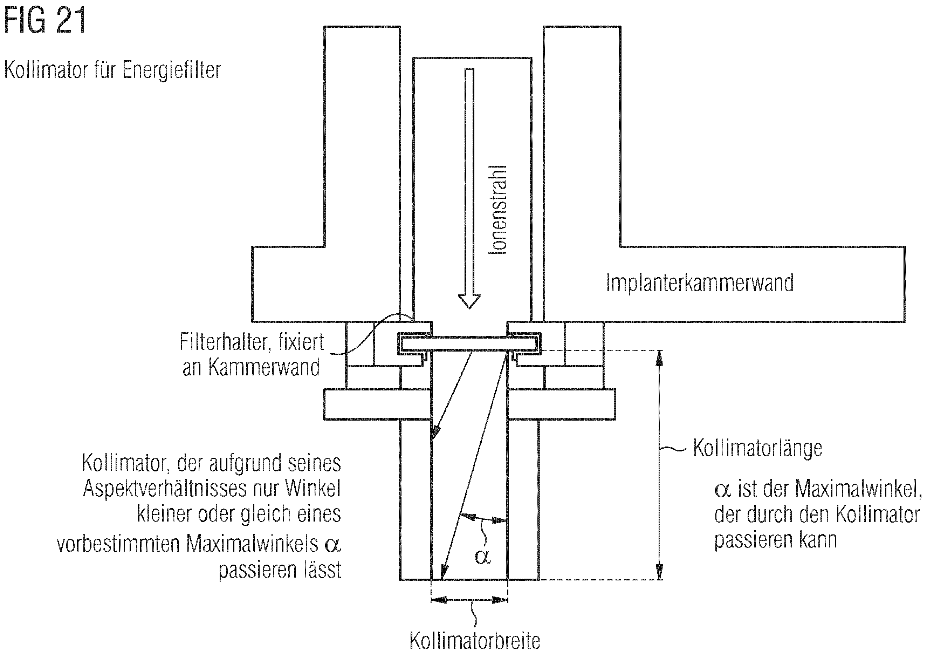

Figur 21 zeigt eine Kollimatorstruktur, welche an einem Filterhalter fixiert ist. Das Aspektverhältnis bestimmt den Maximalwinkel a. Sollte der zur Verfügung stehende Abstand zum Implantationssubstrat nicht ausreichen, so kann der Kollimator auch aus mehreren nebeneinander angeordneten Kollimatoreinheiten mit kleinerer Öffnung bestehen. Diese können z.B. wabenförmig angeordnet sein

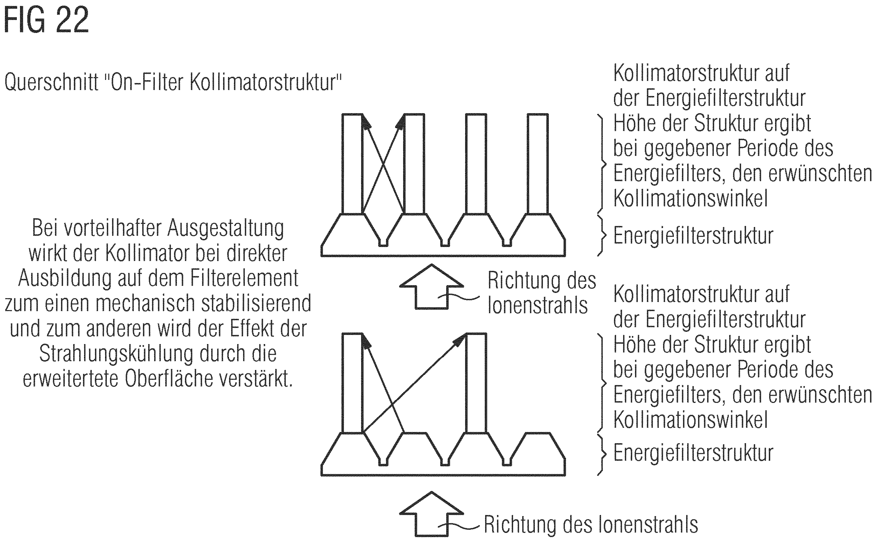

Figur 22 zeigt eine Kollimatorstruktur, welche direkt auf dem Filter aufgebaut ist. Das Aspektverhältnis bestimmt den Maximalwinkel a. Hier wird das Filter in Rückseiten zu Frontseiten Konfiguration im Ionenstrahl platziert. Der Kollimator wirkt bei vorteilhafter Ausgestaltung mechanisch stabilisierend auf den Filter und verbessert aufgrund der vergrößerten Oberfläche des Fiterchips die Kühlung durch Strahlung.

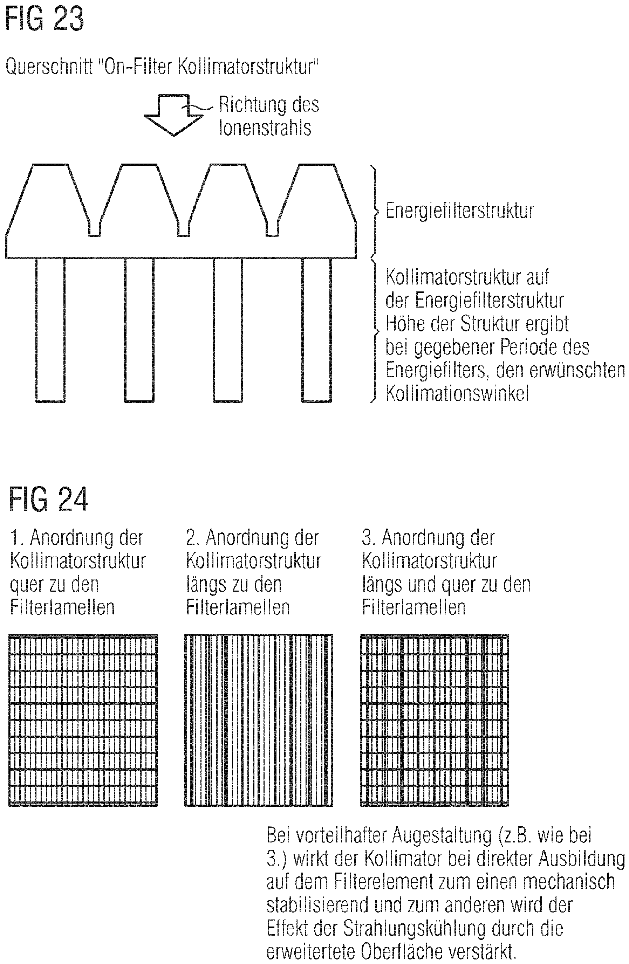

Figur 23 zeigt Kollimatorstruktur, welche direkt auf dem Filter aufgebaut ist. Das Aspektverhältnis bestimmt den Maximalwinkel a. In dem Beispiel ist das Filter in Frontseiten- zu Rückseiten-Konfiguration im Ionenstrahl platziert.
Figur 24 zeigt eine Kollimatorstruktur, welche direkt auf dem Filter aufgebaut ist. Die Kollimatorstruktur kann lamellenförmig, streifenförmig, röhrenartig oder wabenförmig aufgebaut sein - je nach Layout des Filters und der benötigten maximalen Winkelverteilung.

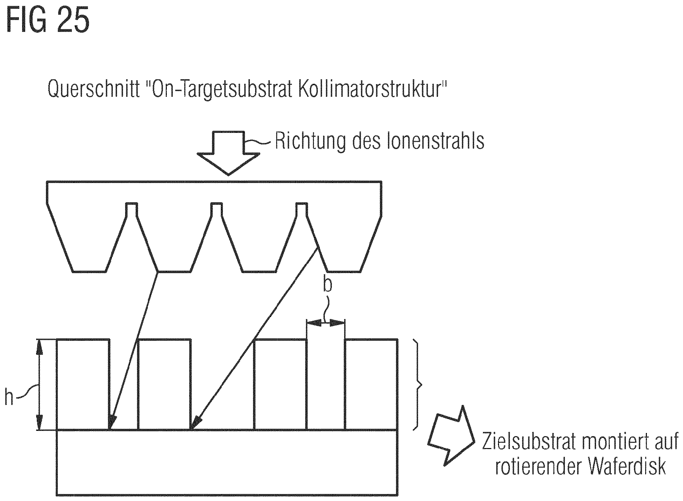

Figur 25 zeigt eine Kollimatorstruktur, welche direkt auf dem Zielsubstrat aufgebaut ist. Die Kollimatorstruktur kann lamellenförmig, streifenförmig, röhrenartig oder wabenförmig aufgebaut sein - je nach Layout der Substratstruktur und der benötigten maximalen Winkelverteilung.

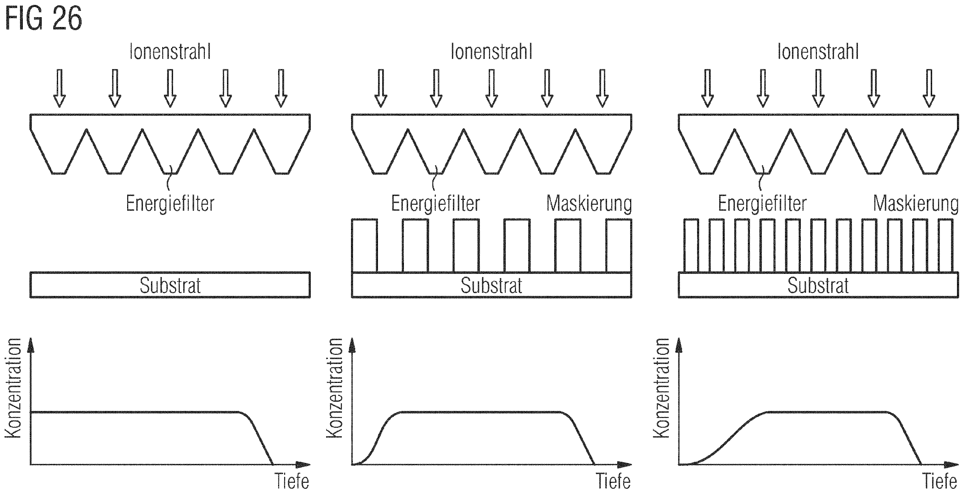

Figur 26 veranschaulicht Dotierprofile, die bei gleichem Filter aber unterschiedlichen Kollimatorstrukturen erhalten werden.

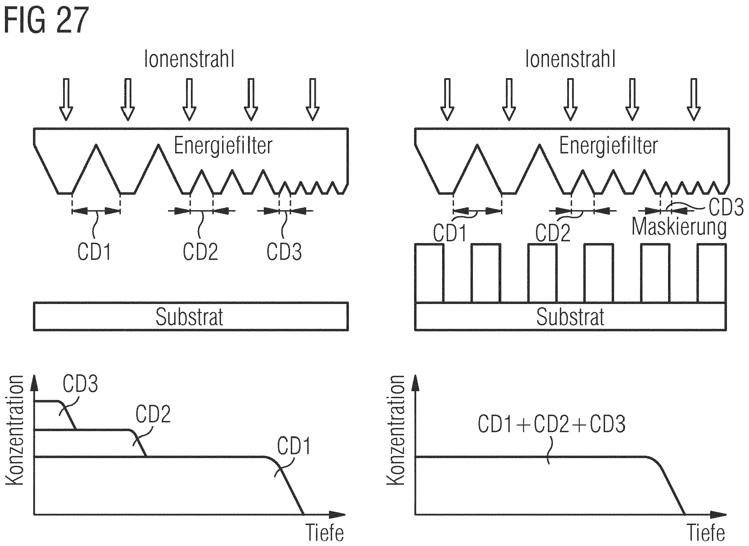

Figur 27 veranschaulicht Dotierprofile, die mittels eines Multifilters bei Implantation mit und ohne Kollimatorstruktur erhalten werden.

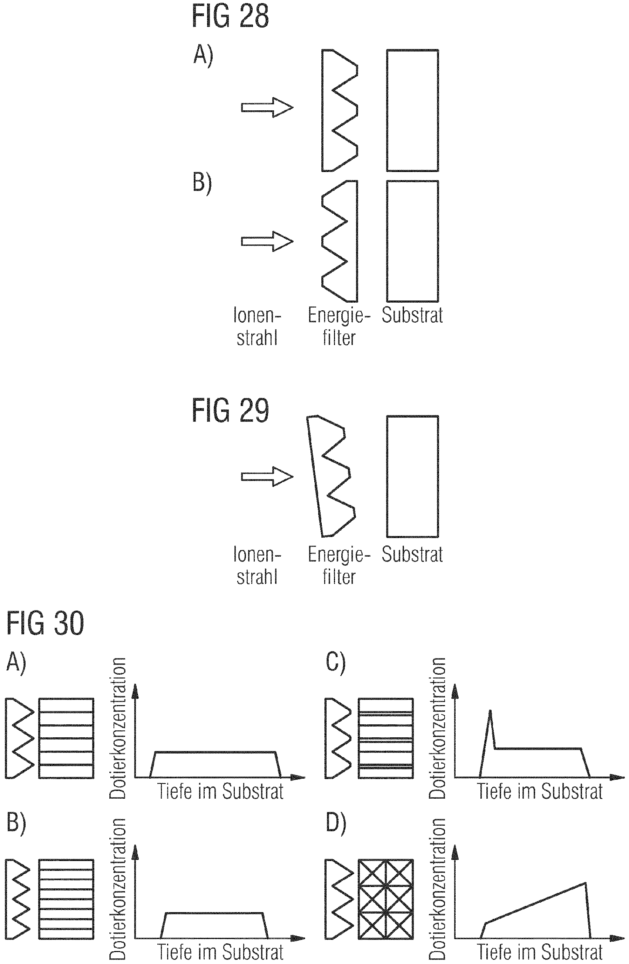

Figur 28 veranschaulicht schematisch ein "Umdrehen des Filters". (a) Das Filter wird in regulärer Anordnung benutzt, d.h. dass die Mikrostrukturen vom Strahl wegzeigen. (b) Das Filter kann umgedreht werden, d.h. dass die Mikrostrukturen zum Strahl hinzeigen. Dies hat vorteilhafte Auswirkungen auf Sputtereffekte im Filter.
Figur 29 veranschaulicht schematisch ein "Kippen des Filters". Ist das Energiefilter aus anisotropen Materialien gefertigt, kann es zum Channeling-Effekt kommen. Dies kann durch eine Kippung des Energiefilters verhindert werden.
Figur 30 zeigt schematisch verschiedene Dotierprofile (Dotierkonzentration als Funktion der Tiefe im Substrat) für unterschiedlich geformte Energiefiltermikrostrukturen (jeweils in Seitenansicht und Aufsicht dargestellt). (a) Dreiecksprismenförmige Strukturen erzeugen ein rechteckförmiges Dotierprofil. (b) Kleinere dreiecksprismenförmige Strukturen erzeugen ein weniger tiefenverteiltes Dotierprofil. (c) Trapezprismenförmige Strukturen erzeugen ein rechteckförmiges Dotierprofil mit einem Peak am Profilbeginn. (d) Pyramidenförmige Strukturen erzeugen ein dreiecksförmiges, in die Tiefe des Substrates ansteigendes Dotierprofil.

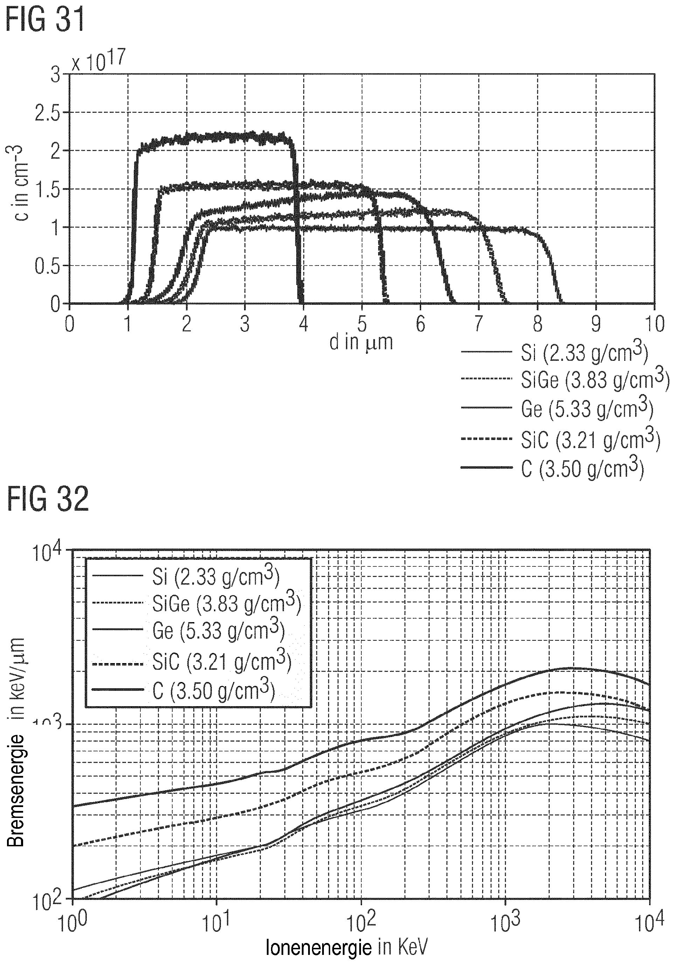

Figur 31 zeigt verschiedene Zielprofilformen bei gleichem Primärion und gleicher Primärenergie, aufgrund unterschiedlicher Targetmaterialien. Das Filtermaterial ist jeweils Silizium.
Figur 32 veranschaulicht den Verlauf des Abbremsvermögens als Funktion der Energie [4] (SRIM-Simulation).

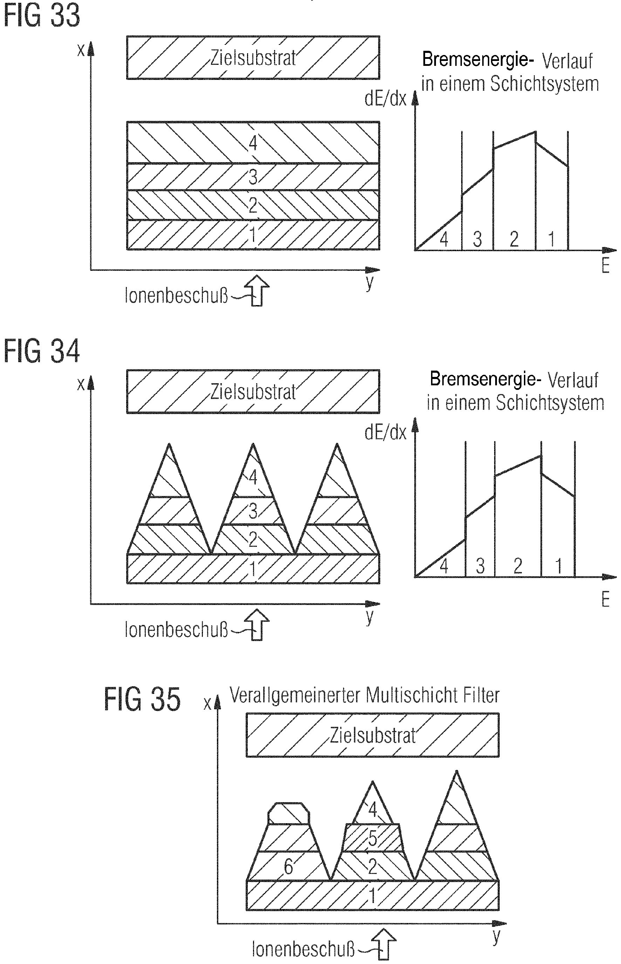

Figur 33 veranschaulicht das Ausgangmaterial eines einfachen Mehrschichtfilters. Filtermaterialien mit geeignetem Abbremsvermögen werden durch geeignete Abscheideverfahren sequentiell aufeinander angeordnet.
Figur 34 veranschaulicht, wie bei geeigneter Ausgestaltung des Schichtstapels von Materialien mit unterschiedlichem Abbremsvermögen selbst bei einfacher Filtergeometrie (hier: streifenförmige Dreiecke) komplexe Dotierstofftiefenprofile realisiert werden können.
Figur 35 veranschaulicht einen verallgemeinerten Aufbau eines Energiefilters, aus Materialien 1 - 6 und mit verschiedenen Geometrien der einzelnen Filterstrukturen.

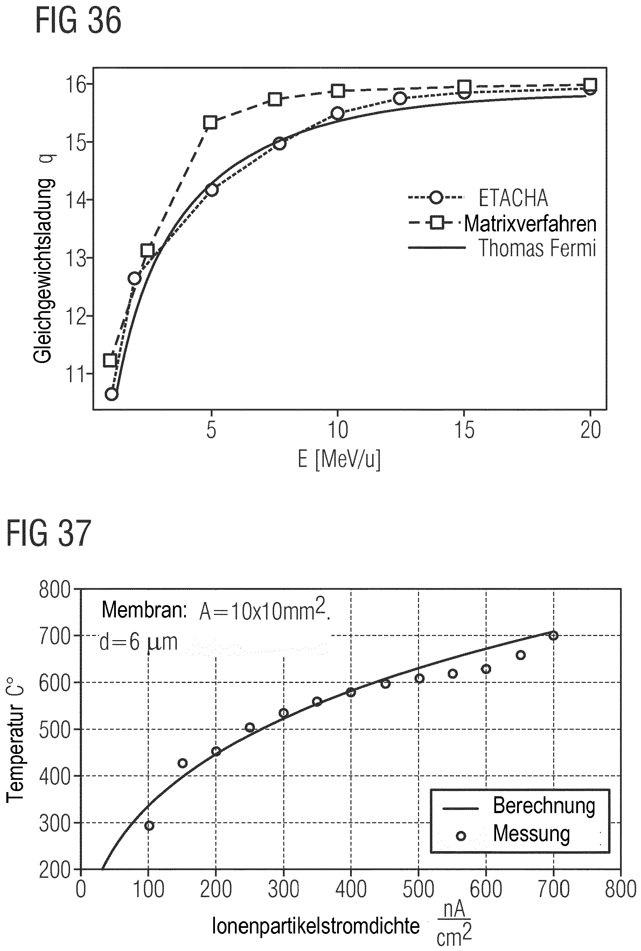

Figur 36 veranschaulicht Gleichgewichtsladungszustande eines Ions (Schwarze Linie: Thomas-Fermi-Abschätzung, Blaue Linie: Monte-Carlo-Simulationen, Rote Linie: Experimentelle Ergebnisse) als Funktion der kinetischen Energie des Ions beim Durchstrahlen einer dünnen Membran. Ion: Schwefel, Membran: Kohlenstoff. [27]
Figur 37 veranschaulicht die Erwärmung eines Energiefilters durch Ionenbeschuss; 6MeV C Ionen in für diese Bedingungen nicht transparenten Energiefilter [2].

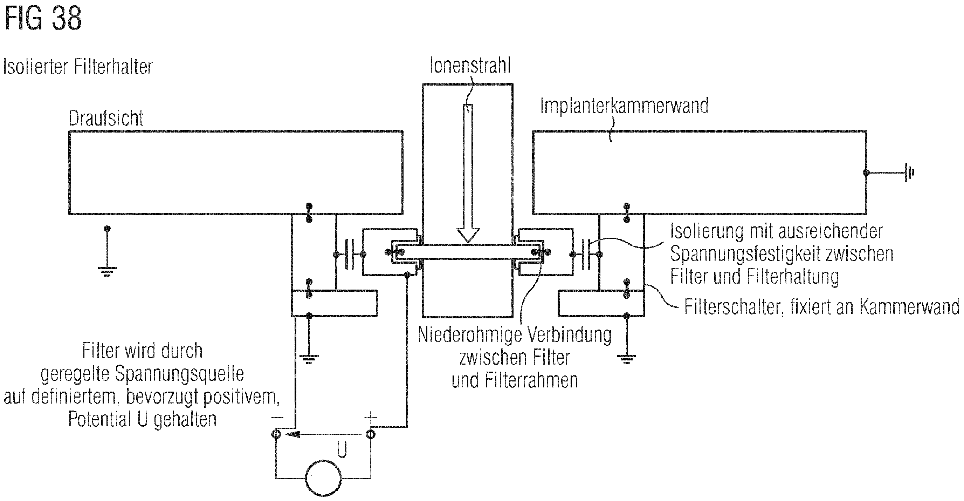

Figur 38 zeigt eine Ausführung einer Filteranordnung bei welcher das Filter im Filterrahmen, zum Zwecke der Unterdrückung von Sekundärelektronen, gegenüber dem Filterhalter auf einem definierten (positiven) Potential gehalten wird.

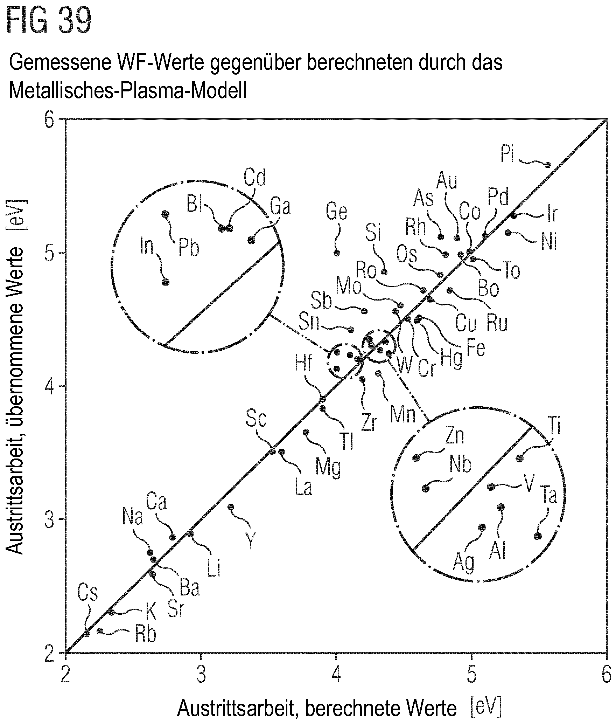

Figur 39 veranschaulicht Austrittsarbeiten einiger Elemente. [25] Materials Science-Poland, Vol. 24, No. 4, 2006

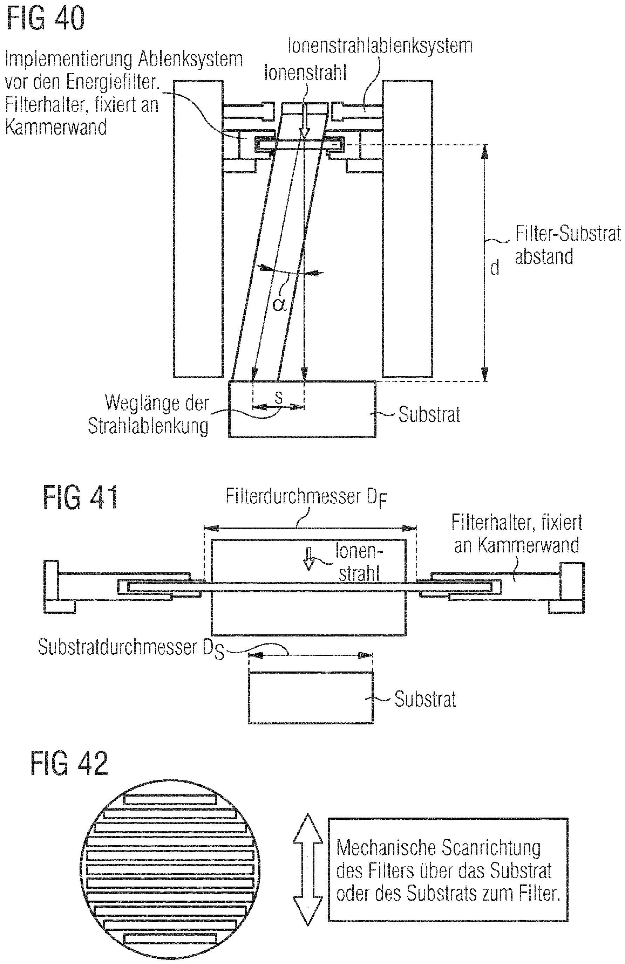

Figur 40 zeigt eine Anordnung für eine Energiefilter-Implantation, in der mittels Ionen-Ablenksystem vor dem Filter und geeignetem Abstand zwischen Filter und Substrat (typischerweise im Bereich von einigen cm bis einigen m) die komplette Bestrahlung eines statischen Substrates erreicht wird.
Figur 41 zeigt eine Anordnung für eine Energiefilter-Implantation, in der durch die größere Fläche des Energiefilters im Vergleich zum Substrat eine komplette Bestrahlung des Substrats erreicht werden kann und eine große Filterfläche genutzt wird. Der bestrahlte Filterbereichdurchmesser ist größer als der Substratdurchmesser.
Figur 42 veranschaulicht ein teilweise aktives Filter mit mechanischem Scan in eine Richtung.

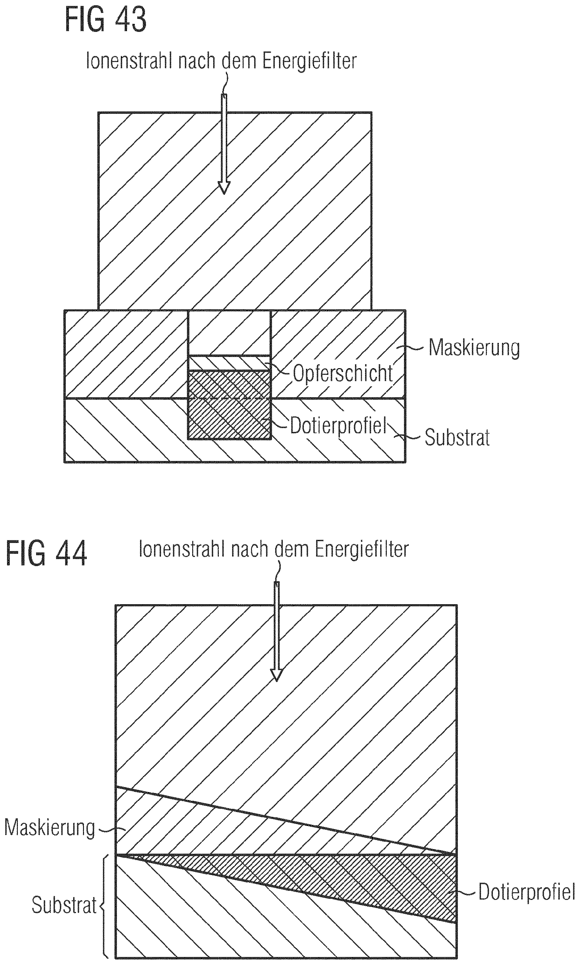

Figur 43 veranschaulicht eine Modifizierung des Dotierprofils im Substrat mittels Opferschicht im Fall einer maskierten, energiegefilterten Implantation. Im hier gezeigten Beispiel wird der Anfang des Implantationsprofils in die Opferschicht geschoben. Dieses Prinzip kann analog für unmaskierte, energiegefilterte Ionenimplantation genutzt werden.
Figur 44 veranschaulicht eine laterale Modifikation des Dotierprofils im Substrat mittels Opferschicht im Fall einer unmaskierten, energiegefilterten Ionenimplantation. Die laterale Tiefenmodifikation kommt durch die lateral unterschiedliche Dicke der Opferschicht zustande. Das Prinzip ist analog für maskierte, energiegefilterte Implantationen einsetzbar.

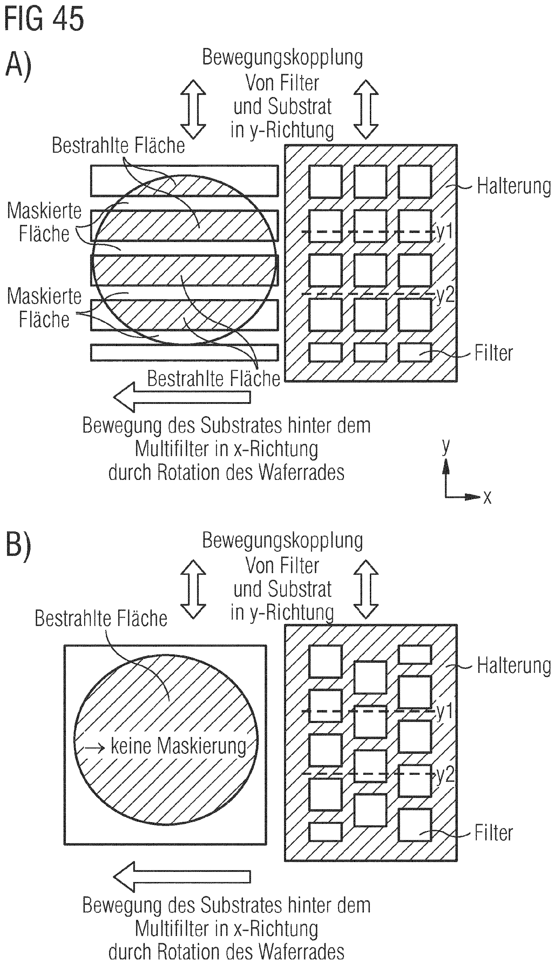

Figur 45 veranschaulicht eine Kopplung vertikaler Bewegungen in y-Richtung von Filter und Substrat. Die Wafer werden durch die Rotation des Waferrades in x-Richtung hinter dem Substrat entlang geführt. Der Ionenstrahl (nicht dargestellt) ist bspw. in x-Richtung aufgeweitet und wird durch die vertikale Pendelbewegung der Implantationskammer über die komplette Multifilterfläche gescannt. Die Fläche besteht aus aktiven Filterbereichen und inaktiven Halterungsbereichen. Die in A) gezeigte Anordnung ist eine ungünstige Anordnung. Betrachtet man für y1 und y2 die bestrahlte Filterfläche, so werden bei y1 3 Filter bestrahlt während bei y2 gar kein Filter bestrahlt wird. Als Resultat erhält man ein lateral inhomogenes Streifenmuster auf dem Wafer. Die in B) gezeigte Anordnung ist ein mögliches Beispiel einer besseren Anordnung. Sowohl für y1 und y2 werden jeweils 2 Filter bestrahlt. Dies gilt für alle y. Dadurch wird eine lateral homogene Dotierung über die Waferfläche erreicht.

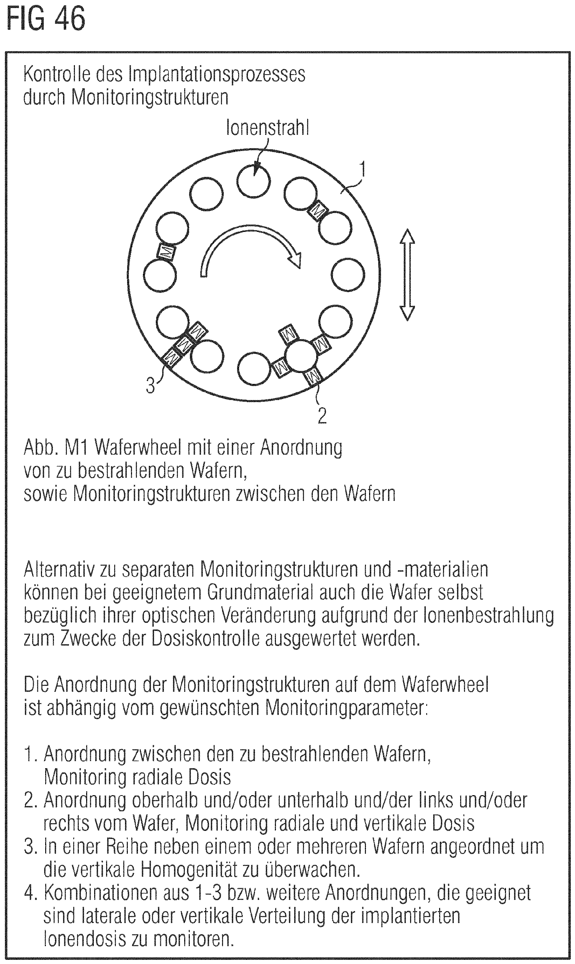

Figur 46 zeigt ein Waferwheel mit einer Anordnung von zu bestrahlenden Wafern, sowie Monitoringstrukturen zwischen den Wafern.

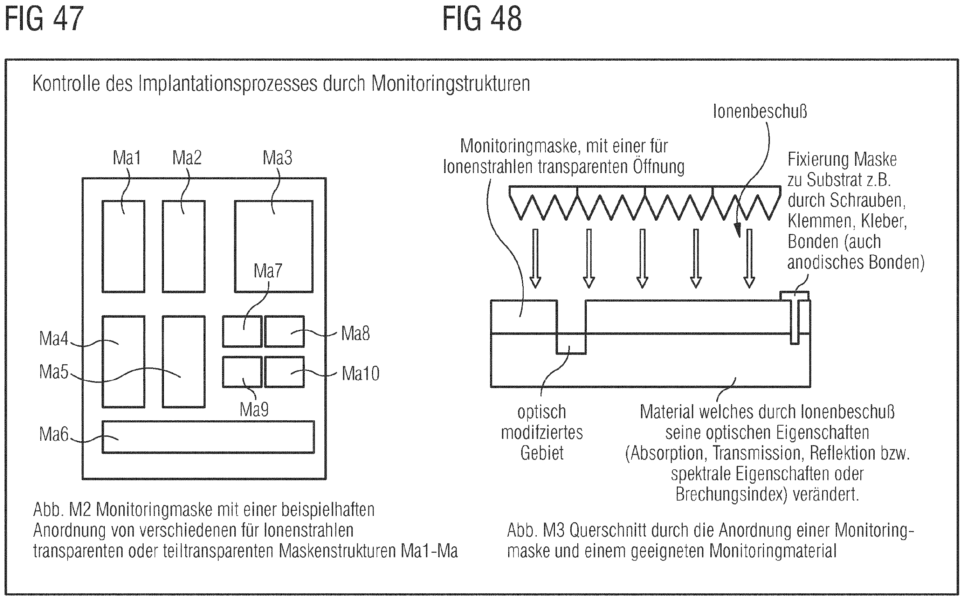

Figur 47 zeigt eine Monitoringmaske mit einer beispielhaften Anordnung von verschiedenen für Ionenstrahlen transparenten oder teiltransparenten Maskenstrukturen Ma1-Ma10.
Figur 48 zeigt einen Querschnitt durch eine Monitoringmaske und ein Monitoringmaterial.

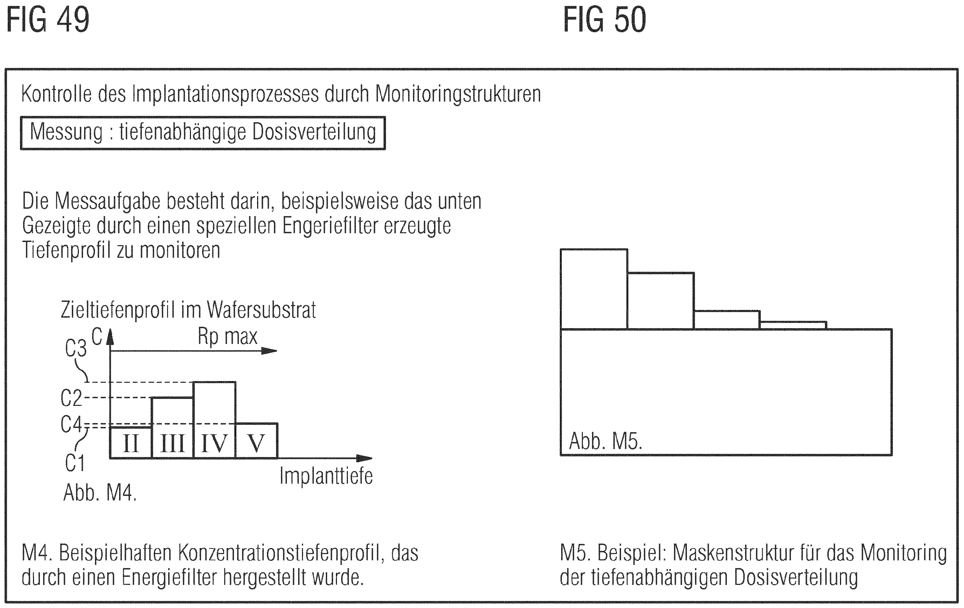

Figur 49 zeigt ein beispielhaftes Konzentrationstiefenprofil, das durch ein Energiefilter hergestellt wurde.
Figur 50 zeigt ein Beispiel einer Maskenstruktur für das Monitoring der tiefenabhängigen Dosisverteilung.

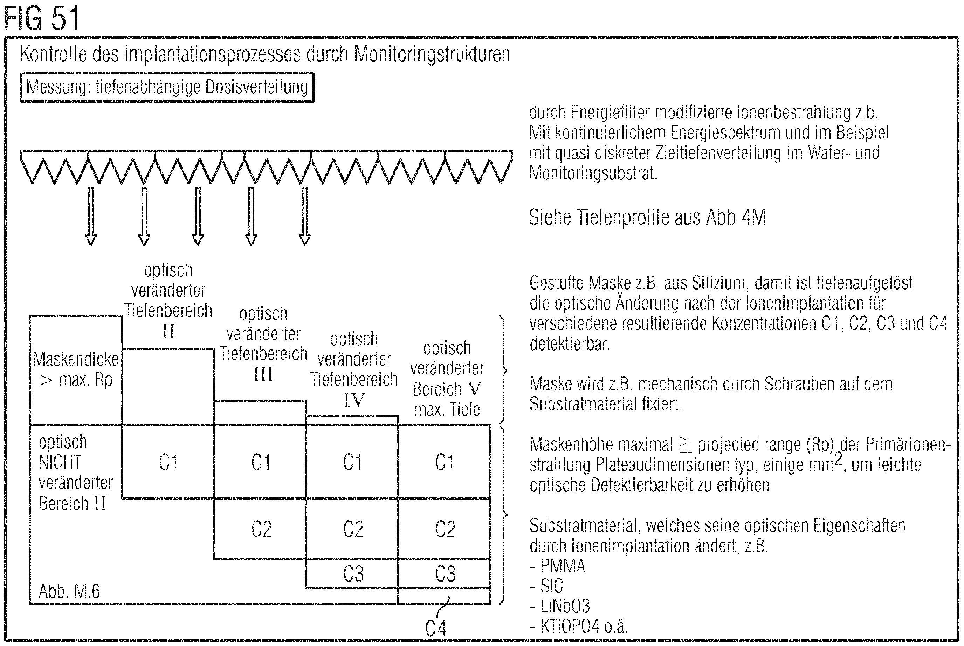

Figur 51 veranschaulicht die Kontrolle des Implantationsprozesses durch Monitoringstrukturen.

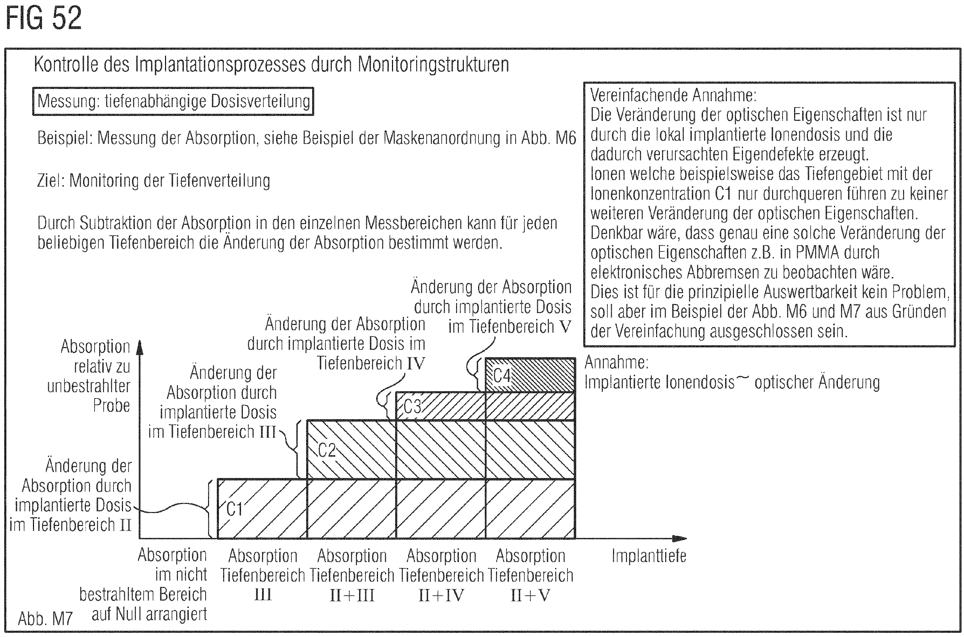

Figur 52 veranschaulicht die Kontrolle des Implantationsprozesses durch Monitoringstrukturen.

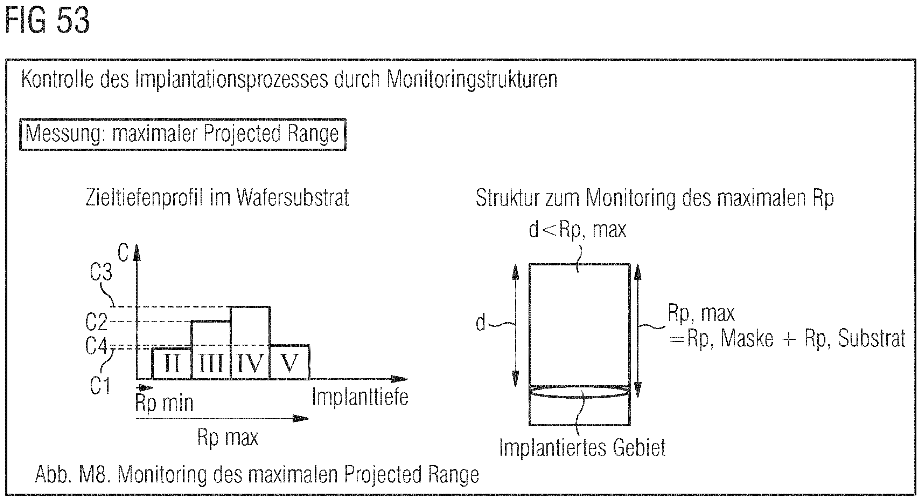

Figur 53 veranschaulicht ein Monitoring des maximalen Projected Range.

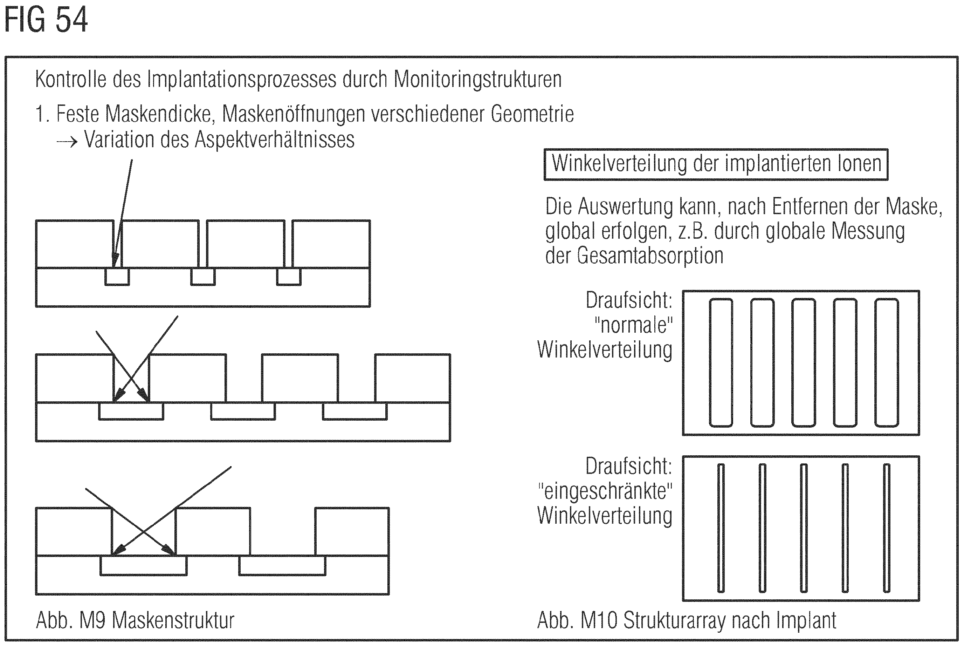

Figur 54 veranschaulicht eine Maskenstruktur.

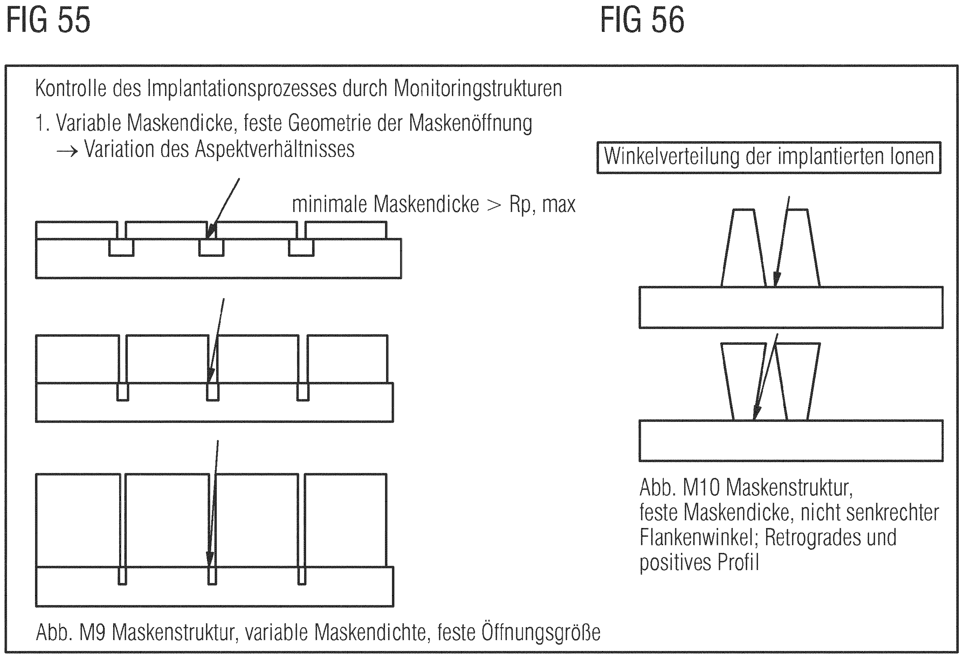

Figur 55 veranschaulicht ein weiteres Beispiel einer Maskenstruktur.
Figur 56 veranschaulicht ein weiteres Beispiel einer Maskenstruktur.

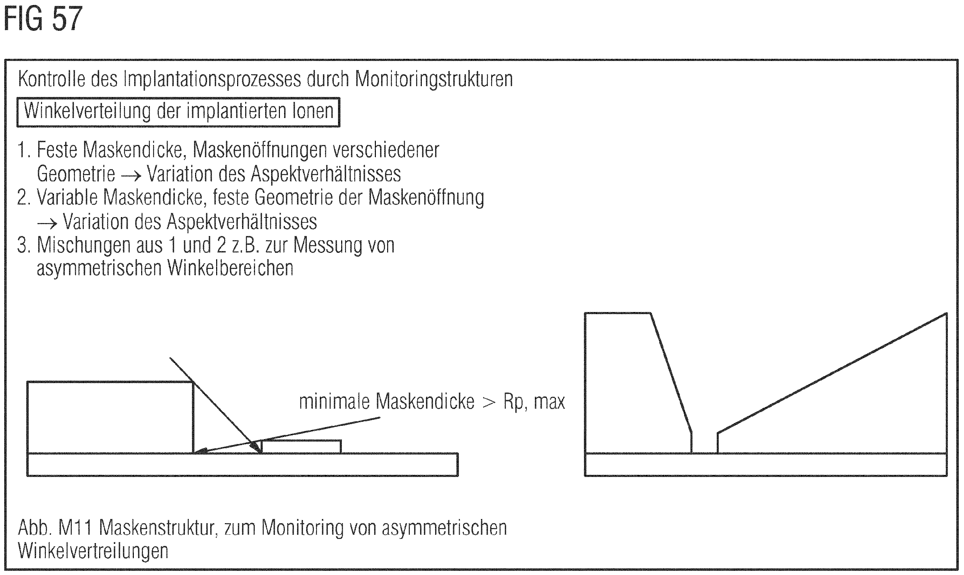

Figur 57 veranschaulicht eine Maskenstruktur zum Monitoring von asymmetrischen Winkelverteilungen.

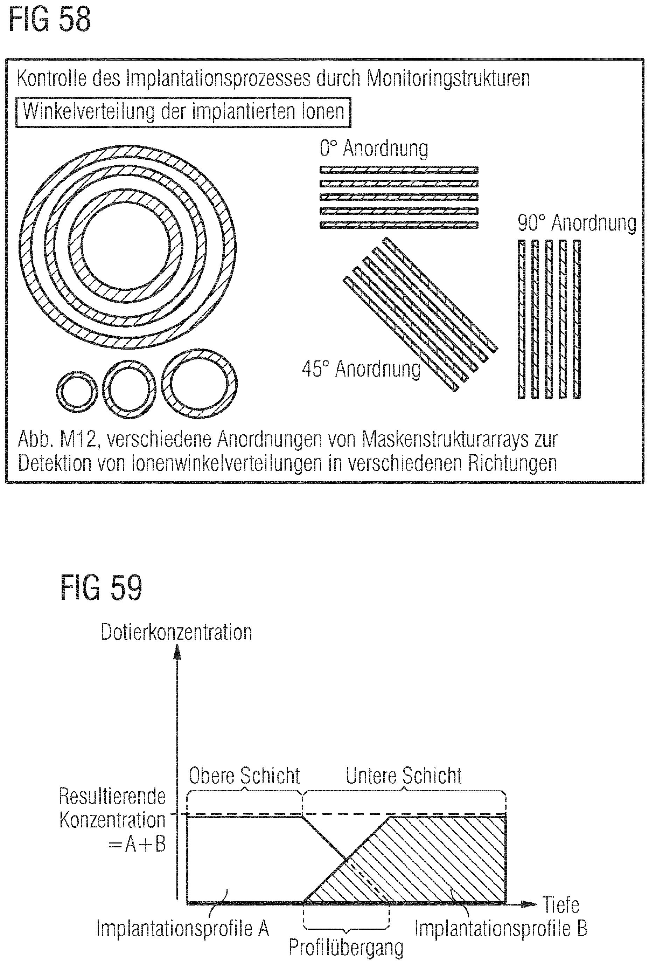

Figur 58 veranschaulicht verschiedene Anordnung von Maskenstrukturen zur Detektion von Ionenwinkelverteilungen in verschiedenen Richtungen.
Figur 59 veranschaulicht die Anpassung eines Profilübergangs zweier Implantationsprofile A und B in geschickter Art und Weise, sodass das resultierende Gesamtkonzentrationsprofil beispielsweise ein gewünschtes homogenes Profil erzeugen kann. Dies kann (muss aber nicht) insbesondere bei Schichtsystemen aus 2 Schichten wie im hier gezeigten Bild vorteilhaft sein.

Vorschlag für eine Realisierung mit folgender Prozessreihenfolge: 1) Dotieren der unteren Schicht (Implant B). 2) Aufwachsen der oberen Schicht. 3) Dotieren der oberen Schicht. Bei der Ausgestaltung des hochenergetischen Schwanzes des Implant A bleiben nur begrenzte Möglichkeiten, allerdings kann der niederenergetische Schwanz von Implant B insbesondere durch das Einbringen einer Opferschicht beeinflusst werden, wie sie in "15: Modifizierung des Dotierprofils im Substrat mittels Opferschicht" beschrieben ist. Vorschlag für eine Realisierung mit folgender Prozessreihenfolge: 1) Aufwachsen Opferschicht. 2) Dotieren der unteren Schicht (Implant B). 3) Entfernen der Opferschicht 4) Aufwachsen der oberen Schicht. 5) Dotieren der oberen Schicht.

### DETAILLIERTE BESCHREIBUNG

Figur 1 zeigt ein aus [7] bekanntes Verfahren zur Erzeugung eines Tiefenprofils. Hierbei erfolgt eine Implantation eines Ionenstrahls in ein Substrat durch ein strukturiertes Energiefilter in einer Anlage zur Ionenimplantation zum Zwecke der Waferprozessierung. Dargestellt ist das Implantationsverfahren und die aus der Implantation resultierende Dotierstoffverteilung bzw. Defektverteilung in dem Wafer nach der Prozessierung. Dargestellt ist insbesondere, wie ein monoenergetischer Ionenstrahl beim Durchtritt durch eine mikrostrukturierte Energiefilterkomponente abhängig vom Eintrittsort in seiner Energie modifiziert wird. Die resultierende Energieverteilung der Ionen führt zu einer Modifikation des Tiefenprofils des implantierten Stoffes in der Substratmatrix. Dieses Tiefenprofil, das in dem dargestellten Beispiel rechteckförmig ist, ist in Figur 1 ebenfalls dargestellt.

Figur 2 zeigt eine Anlage zur Ionenimplantation. Diese Anlage umfasst eine Implantationskammer (Implantation chamber), in der mehrere Wafer auf einem Waferrad angeordnet werden können. Das Waferrad dreht sich während der Implantation, so dass die einzelnen Wafer immer wieder eine Strahlöffnung (Beam opening) passieren in der das Energiefilter angeordnet ist und durch die der Ionenstrahl in die Implantationskammer, und damit in die Wafer gelangt. Links in Figur 2 ist das Waferrad gezeigt, auf welchem die zu implantierenden Substrate fixiert werden. Bei der Prozessierung/Implantation wird das Rad um 90° nach gekippt und in Rotation versetzt. Das Rad wird somit in konzentrischen Kreisen durch den in grün angedeuteten Ionenstrahl mit Ionen "beschrieben". Um die gesamte Waferfläche zu bestrahlen, wird das Rad während der Prozessierung vertikal bewegt. Rechts in Figur 2 ist ein in der Strahlöffnung montiertes Energiefilter gezeigt.

Figur 3 zeigt beispielhaft Layouts bzw. dreidimensionalen Strukturen von Filtern, um prinzipiell zu veranschaulichen, wie eine Vielzahl von unterschiedlichen Dotierstofftiefenprofilen durch eine geeignete Wahl des Filters erzeugt werden kann. Die einzelnen, in Figur 3 dargestellten Filterprofile können miteinander kombiniert werden um weitere Filterprofile und somit Dotiertiefenprofile zu erhalten. Dargestellt sind jeweils Querschnitte des Energiefilters (in den Abbildungen jeweils ganz links), Draufsichten auf die Energiefilter und Verläufe der erreichten Dotierungskonzentration über die Tiefe (als Funktion der Tiefe) des Wafers. Die "Tiefe" des Wafers ist eine Richtung senkrecht zu der Oberfläche des Wafers, in die implantiert wird. Wie in Figur 3 gezeigt ist, bewirken (a) dreiecksprismenförmige Strukturen ein rechteckförmiges Dotierprofil, (b) kleinere dreiecksprismenförmige Strukturen ein im Vergleich zu Fall (a) weniger tief reichende rechteckförmiges Dotierprofil (die Tiefe des Profils kann also über die Größer der Strukturen eingestellt werden),, (c) trapezprismenförmige Strukturen ein rechteckförmiges Dotierprofil mit einem Peak am Profilbeginn, und (d) pyramidenförmige Strukturen ein dreiecksförmiges, in die Tiefe des Substrates ansteigendes Dotierprofil.

Bisher bekannte Energiefilter (Implantationsfilter) bzw. Energiefilterelemente sind aus verschiedenen Gründen nicht geeignet um hohe Durchsätze, d.h. viele Wafer pro Stunde, zu erreichen. Wünschenswert ist es insbesondere, hohe Waferdurchsätze pro Stunde, einfache Handhabbarkeit, einfache Herstellung und die Realisierung beliebiger Profilformen. Aus der Literatur sind statische oder beweglich montierte Filter bekannt, welche monolithisch, d.h. aus einem Materialblock hergestellt sind und einzeln zum Ionenstrahl montiert sind [2], [3], [4], [5], [6], [7], [8],[9], [10]. Im Gegensatz zu Silizium können dotierte Gebiete in SiC-Wafern i.a. nicht durch Ausdiffusion von Dotierprofilen in ihrer Form verändert werden[2],[4], [5], [6]. Der Grund liegt in den auch bei hohen Temperaturen sehr geringen Diffusionskonstanten der gängigen Dotanten (Dotierstoffe), wie Al, B, N, P. Diese liegen viele Größenordnungen unter den Vergleichswerten von beispielsweise Silizium. Aufgrund dieser Tatsache ist es bislang nicht möglich, Dotiergebiete, insbesondere solche mit hohen Aspektverhältnissen, d.h. kleinen Verhältnis von Grundfläche zu Tiefe, wirtschaftlich zu realisieren.

Dotiertiefenprofile in Halbleiterwafern können durch insitu-Dotierung während der epitaktischen Abscheidung oder durch (maskierte) monoenergetische Ionenimplantation hergestellt werden. Bei einer insitu-Dotierung können hohe Ungenauigkeiten auftreten. Selbst bei homogenen Dotierprofilen sind prozessbedingt auf dem Wafer, d.h. von Mitte zu Rand signifikante Abweichungen von der Zieldotierung zu erwarten. Für Gradiententiefenprofile erstreckt sich diese Ungenauigkeit auch auf die vertikale Richtung des Dotiergebietes, da nun die lokale Dotierstoffkonzentration von einer Vielzahl von Prozessparametern wie etwas Temperatur, lokale Dotiergaskonzentration, Topologie, Breite der Prandtl'schen Grenzschicht, Aufwachsrate etc. abhängt. Der Einsatz monoenergetischer Ionenstrahlen bedeutet, dass viele Einzelimplantationen durchgeführt werden müssen um Dotierprofile mit akzeptablen vertikalen Welligkeiten zu erhalten. Dieser Ansatz ist nur bedingt skalierbar, er wird sehr schnell wirtschaftlich unrentabel.

Beispiele der Erfindung betreffen die Ausgestaltung eines Energiefilterelements für Ionenimplantationsanlagen, sodass dieses den Anforderungen, die sich aus der Anwendung des Energiefilterelements bei der industriellen Produktion von Halbleiterbauelementen, insbesondere für Bauelemente auf Basis von SiC Halbeitermaterial, ergeben, entspricht. Produktionsbedingungen definieren sich im Hinblick auf den Einsatz von Energiefilterelementen beispielsweise durch folgende Aspekte:

### 1. Technisch einfacher Filterwechsel

In einem produktiven Umfeld, d.h in einer Fabrik, wird die Produktion auch an Ionenimplantern durch gewerbliche Mitarbeiter ("Operator"), die in den meisten Fällen keine Ingenieursausbildung durchlaufen haben, durchgeführt.

Das Energiefilter ist eine höchst fragile mikrostrukturierte Membran, deren zerstörungsfreies Handling schwierig ist. Für den wirtschaftlichen Einsatz der Filtertechnik sollte gewährleistet sein, dass nach einer kurzen Einweisung auch Nicht-Fachleute (im Sinne von Nicht-Ingenieure) in der Lage sein müssen den Filter nach Verschleiß oder im Sinne eines Werkzeugwechsels an der Implanteranlage auszutauschen.

### 2. Beliebige Vertikale Profilformen

Neuartige Halbleiterbauelemente wie z.B. Superjunction Bauelemente oder optimierte Diodenstrukturen bedingen einen nicht gleichförmigen Dotierverlauf. Die einfachen in [1-6] beschriebenen Energiefilter erzeugen jedoch lediglich konstante Profile. Kompliziertere Filterstrukturen wie z.B. in Rüb [8] beschriebene Strukturen sind technisch sehr aufwändig und gemäß dem Stand der Technik für produktive Aufgaben schwer realisierbar. Es stellt sich die Aufgabe, komplizierte vertikale Profilformen mit unkomplizierten, d.h. einfach herstellbaren Filterstrukturen zu realisieren.

### 3. Hoher Durchsatz -Kühlsysteme in Kombination mit Filterbewegung

Produktionsbedingungen bedeuten beispielsweise, dass an Ionenimplantern (typische Terminalspannung an Tandembeschleunigern > 1MV bis 6MV) pro Stunde mehr als typisch 20-30 Wafer mit 6" Durchmesser und Flächendosen pro Wafer von ca. 2E13cm-2 erzeugt werden sollen. Um für diesen Fall die geforderte Anzahl an Wafern produzieren zu können müssen Ionenströme von mehr als 1pµA bis hin zu einigen 10pµA zum Einsatz kommen bzw. es werden Leistungen von mehr als einigen Watt, z.B. 6W/cm-2 auf dem Filter (typische Fläche 1-2cm²) deponiert. Dies führt zur Erwärmung des Filters. Es stellt sich die Aufgabe, den Filter durch geeignete Maßnahmen zu kühlen.

### 4. Einfache, kostengünstige Herstellung der Filterstrukturen für den Fall homogener konstanter Tiefenprofile

Filterstrukturen können mittels anisotropem nasschemischem Ätzen hergestellt werden. In der einfachsten Ausbildung bestehen die Filterstrukturen aus geeignet dimensionierten dreiecksförmigen langen Lamellen (z.B. 6µm hoch, 8,4µm Abstand, Länge einige Millimeter), die periodisch auf einer möglichst dünnen Membran angeordnet sind. Hierbei ist die Herstellung von spitzen dreiecksförmigen Lamellen kostenintensiv, da die nasschemische anisotrope Ätzung genau eingestellt werden muss. Spitze, d.h. nicht trapezförmige Lamellen sind aufwändig, da für spitze Lamellen Ätzraten und Ätzzeiten genau aufeinander abgestimmt sein müssen. In der Praxis führt das zu hohem Aufwand bei der Prozesskontrolle während der Ätzung und es führt aufgrund der zu erwartenden ungleichmäßigen Prozessierung (Ätzraten nasschemischer Prozesse sind niemals perfekt reproduzierbar und sind niemals homogen über größere Flächen) auf einem Chip mit vielen hundert Lamellen zu Ausbeuteverlusten, d.h. nicht perfekt strukturierten Filterelementen. Es stellt sich die Aufgabe, eine einfache und kostengünstige Energiefilterproduktion zu realisieren.

### 5. Hohe laterale Homogenität des erzeugten Dotier- bzw. Defektgebietes

Die in den genannten Druckschriften [2], [3], [4], [5], [6], [7], [8],[9], [10] beschriebenen Energiefilter für Ionenimplantation haben eine interne 3-dimensionale Struktur, die zu Weglängenunterschieden der Ionen bei Transmission durch den Filter führt. Diese Weglängenunterschiede erzeugen, abhängig von Bremsvermögen des Filtermaterials, eine Modifikation der kinetischen Energie der transmittierten Ionen. Ein monoenergetischer Ionenstrahl wird somit in einen Strahl von Ionen mit unterschiedlicher kinetischer Energie umgewandelt. Die Energieverteilung wird durch die Geometrie und die Materialien des Filters bestimmt, d.h., die Filterstruktur wird ionenlithographisch in das Substrat übertragen.

### 6. Überwachung des "End of Life" für den Energiefilter

Aufgrund der nuklearen Wechselwirkung der Ionenstrahlen mit dem Filtermaterial und aufgrund der thermischen Belastung ergibt sich spezifisch für jeden Ionenimplantationsprozess mit Energiefilter eine typische Lebensdauer des Filters. Für einen Energiefilter aus Silizium, mit ca. 2µm Stützschicht, 8µm regelmäßigen Zackenstrukturen und einem Implantationsprozess von 12MeV Stickstoff mit Strömen um 0.1pµA ergibt sich eine ungefähre maximale Produktionsmenge von ca. 100 Wafern (6").

Für den Maschinenbediener und zur Absicherung des Filterherstellers sollte die Gesamtzahl der mit einem spezifischen Filter bearbeiteten Wafer überwacht werden.

### 7. Einschränkung der Winkelverteilung der transmittierten Ionen

Für die Herstellung von maskierten, d.h. in ihrer lateralen räumlichen Ausdehnung eingeschränkten, Dotiergebieten insbesondere in Fällen von hohen Aspektverhältnissen muss das Winkelspektrum der transmittierten Ionen eingeschränkt werden um eine "Unterimplantation" der maskierenden Schicht zu vermeiden.

### 8. Geringer Filterverschleiß durch Sputtereffekte

### 9. Vermeidung von Channelingeffekten (Gitterführungseffekte) durch die Anordnung des Filters zum Ionenstrahl

### 10. Realisierung komplexer Dotierstofftiefenprofile durch einfache Filtergeometrie

### 11. Elektronenunterdrückung bei Verwendung des Filters

Es ist bekannt, dass bei der Transmission von Ionen durch einen Festkörper die Ionen hinsichtlich ihrer elektrischen Ladung einen Gleichgewichtszustand einnehmen. Elektronen des Primärstrahls können im Festkörper abgegeben oder aufgenommen werden, d.h. die transmittierten Ionen haben abhängig von den Eigenschaften des Filtermaterials und der Primärenergie nach Durchgang durch den Filter im Mittel einen höheren oder niedrigeren Ladungszustand [26]. Dies kann zu positiver oder negativer Aufladung des Filters führen.

Gleichzeitig können durch den Ionenbeschuss, sowohl auf der Vorder- als auch auf der Rückseite des Filters Sekundärelektronen mit hoher kinetischer Energie erzeugt werden.

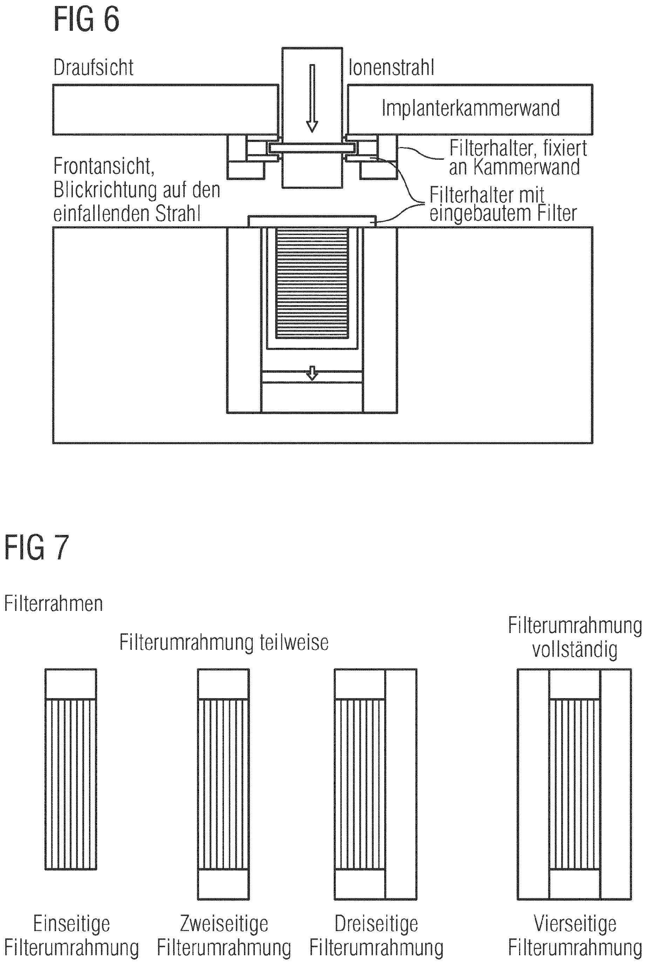

Bei hohen Stromdichten, wie sie in der industriellen Produktion gefordert werden, wird sich das Energiefilter aufheizen, siehe Abb. 6.5.24. Aufgrund thermoionischer Elektronenemission (Richardson-Dushman Gesetz) werden abhängig von der Temperatur und der Austrittsarbeit des Filtermaterials thermische Elektronen erzeugt.

Der Abstand (im Hochvakuum) des Ionenbeschleunigers zwischen Filter und Substrat beträgt typischerweise nur einige Zentimeter oder weniger. D.h. durch Diffusion thermischer Elektronen (aus thermoionischer Emission) und durch Einwirkung schneller Elektronen (aus Ionenbeschuss) wird die Messung des Ionenstroms am Substrat, beispielsweise durch einen dort angebrachten Faraday Cup, verfälscht.

### 12. Alternative Herstellmethoden durch Spritzguss-, Guss- oder Sinterverfahren

In den Druckschriften [2] - [15] werden für die Herstellung des Energiefilters mikrotechnische Verfahren vorgeschlagen. Insbesondere wird beschrieben, dass zur Herstellung der Filter Lithographieverfahren in Kombination mit nasschemischen oder trockenchemischen Ätzverfahren zum Einsatz kommen. Bevorzugt wird für die Filterherstellung auf das anisotrope nasschemische Ätzverfahren mittels alkalischer Ätzmedien (z.B. KOH oder TMAH) in Silizium zurückgegriffen.

Bei Filtern, die nach dem letztgenannten Verfahren hergestellt werden, wird die funktionale Filterschicht aus einkristallinem Silizium hergestellt. Somit muss beim Beschuss mit energiereichen Ionen immer davon ausgegangen werden, dass prinzipiell Channelingeffekte den effektiven Energieverlust in der Filterschicht in schwer kontrollierbarer Weise beeinflussen.

### 13. Anordnung zur Bestrahlung eines statischen Substrates

Es soll eine Bestrahlungsanordnung genutzt werden, die es erlaubt, ein statisches Substrat energiegefiltert mit hoher lateraler Homogenität über die gesamte Substratfläche zu bestrahlen. Grund: Endstations von Bestrahlungsanlagen verfügen häufig über keinen vollmechanischen Scan des Wafers (Waferwheel) unter Verwendung eines punktförmigen bzw. nahezu punktförmigen Beamspots, sondern viele Anlagen verfügen über einen elektrostatisch aufgeweiteten Strahl (=Strich in x-Richtung), der beispielsweise elektrostatisch über den Wafer (y-Richtung) gescannt wird. Teilweise sind auch teil-mechanische Scanner im Einsatz, d.h. Aufweitung des Strahls in x-Richtung und mechanische (langsame) Bewegung des Wafers in y-Richtung.

### 14. Anordnung zur Ausnutzung einer großen Filterfläche

Es muss eine Bestrahlungsanordnung genutzt werden, die es erlaubt, ein statisches oder bewegliches Substrat energiegefiltert mit hoher lateraler Homogenität über die gesamte Substratfläche zu bestrahlen und dabei eine große Filterfläche zu nutzen. Dadurch können thermische Effekte und Degradationseffekte im Filter gemindert werden.

### 15. Modifizierung des Dotierprofils im Substrat mittels Opferschicht

Das Energiefilter ist ein Werkzeug zur Manipulation des Dotierprofils im Substrat. Unter bestimmten Anforderungen ist eine Manipulation des erzeugbaren Dotierprofils im Substrat NACH dem Energiefilter wünschenswert. Insbesondere ein "Herausschieben" des oberflächennahen Anfangs des Dotierprofils aus dem Substrat ist wünschenswert. Dies kann insbesondere vorteilhaft sein, wenn der Anfang des Dotierprofils im Substrat durch den Filter aus verschiedenen Gründen (insbesondere Verlust von Ionen durch Streuung) nicht korrekt eingestellt werden kann. Solch eine Dotierprofilmanipulation nach dem Energiefilter kann durch eine Implantation in eine Opferschicht auf dem Substrat erfolgen.

### 16. Laterale Modifikation des Dotierprofils im Substrat mittels Opferschicht

Für gewisse Anwendungen ist ein lateral veränderliches Dotierprofil im Substrat wünschenswert. Insbesondere könnte die Veränderung der Implantationstiefe eines homogenen Dotierprofiles für Randabschlüsse in Halbleiterbauelementen vorteilhaft eingesetzt werden. Solch eine laterale Einstellung des Dotierprofils kann durch eine lateral in ihrer Dicke veränderliche Opferschicht auf dem Substrat erfolgen.

### 17. Anpassung eines Profilübergangs mehrerer Implantationsprofile

Für gewisse Anwendungen ist es wünschenswert, dass 2 oder mehrere Profile in einer bestimmten Tiefe an einer "Nahtstelle" verbunden werden müssen, da sonst eine Isolation zwischen den Schichten besteht. Insbesondere tritt dieses Problem bei einem Schichtsystem auf, wenn das untere Ende eines oberen Dotierprofils oder das obere Ende eines untenliegenden Dotierprofils einen langsam auslaufenden Konzentrationsschwanz aufweisen.

### 18. Spezielle Anordnung des Multifilterkonzeptes bei gekoppelter Pendelbewegung

Wenn ein Multifilter am beweglichen Teil einer beweglichen Substratkammer befestigt ist, welche sich vor dem Strahl mit einer linearen Pendelbewegung bewegt (z.B. im Fall einer rotierenden Waferdisk mit vertikaler Scan-Einrichtung), so kann eine Bewegung des Multifilters relativ zum Strahl auf einfachem Weg durch die Bewegung der Substratkammer erreicht werden. Durch eine magnetische oder statische Scaneinrichtung vor dem Filter in eine Richtung kann dann eine sehr große Multifilterfläche genutzt werden, die sich bspw. als Produkt aus vertikaler Pendeldistanz und horizontaler Scandistanz ergibt. Die Bewegung von Wafer und Filter sind in dieser Anordnung gekoppelt, was zu Problemen hinsichtlich der lateralen Dotierhomogenität führen kann. Durch die Rotation des Waferrades "schreibt" der Ionenstrahl Linien auf die Wafer. Als Konsequenz der genannten Anordnung ist die Position einer bspw. horizontalen bestrahlten Linie auf dem Wafer gekoppelt zu einer bestimmten vertikalen Position auf dem Multifilter. Eine Lücke zwischen einzelnen Filterelementen würde bspw. eine inhomogen dotierte Linie auf dem Wafer zur Folge haben. Es muss daher eine Anordnung der Filterkomponenten im Multifilter gewählt werden, sodass die laterale Homogenität trotz der Kopplung der linearen Bewegungen von Filter und Substrat gewährleistet ist.

Beispiele von Energiefiltern, von Implantationsvorrichtungen, oder von Teilen von Implantationsvorrichtungen die den zuvor genannten Produktionsbedingungen genügen, sind nachfolgend erläutert. Es sei erwähnt, dass die nachfolgend erläuterten Maßnahmen und Konzepte beliebig miteinander kombiniert werden können, aber auch jeweils einzeln für sich anwendbar sind.

### Ad 1. Technisch einfacher Filterwechsel

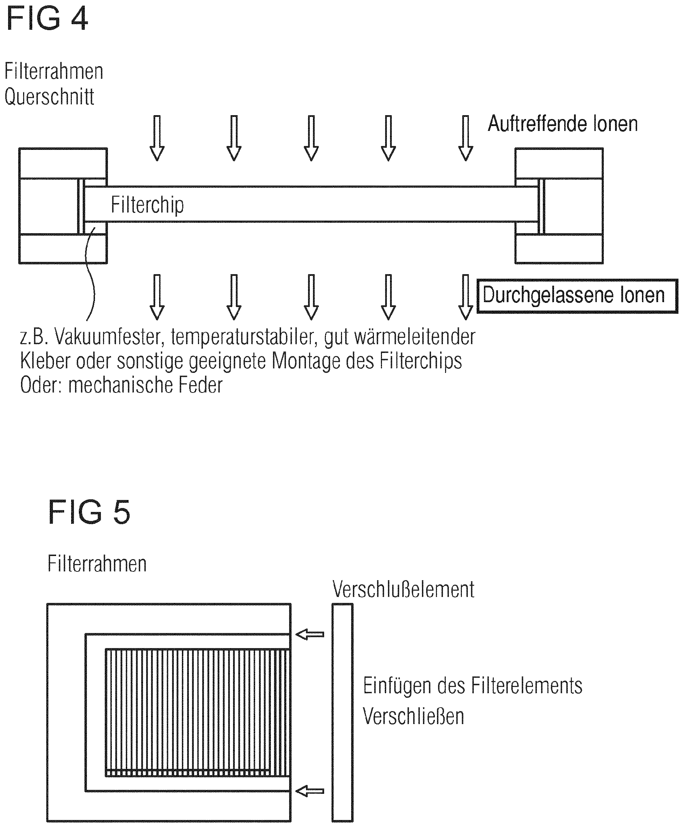

Es wird vorgeschlagen an dem jeweiligen Implantationsfilter, das nachfolgend als Filterchip bezeichnet wird, einen Rahmen vorzusehen, der eine einfache Handhabung des Filterchips ermöglicht. einzubauen. Dieser Rahmen kann, wie in den Figuren 4 bis 6 dargestellt ist, derart gestaltet sein, dass er an der Ionenimplantationsanlage in eine dort vorinstallierte, passende Rahmenhalterung eingesetzt werden kann. Der Rahmen schützt den Energiefilter, erlaubt einfaches Handling und sorgt für elektrische und thermische Ableitung bzw. elektrische Isolierung (siehe Figur 36). Der Rahmen kann vom Hersteller der Filterelemente mit dem Filterchip in einer staubfreien Umgebung bestückt und in einer staubfreien Verpackung bis an die Ionenimplantationsanlage geliefert.

In den Figuren 4 und 5 ist ein Beispiel für die geometrische und mechanische Ausgestaltung eines Filterrahmens dargestellt. Das darin gehaltene Filter kann eine beliebige Oberflächenstruktur aufweisen, die entsprechend des gewünschten, damit zu erreichenden Dotierprofils gewählt ist. Der Filterhalter und/oder der Filterrahmen kann mit einer Beschichtung versehen sein, die einen Materialabtrag vom Filterrahmen und Filterhalter verhindert.

Filterrahmen und Filterhalter können aus Metallen, bevorzugt Edelstahl o.ä. hergestellt sein. Während des Implantationsprozesses muss aufgrund von gestreuten Ionen mit Sputtereffekten im lokalen Umfeld des Energiefilters gerechnet werden, d.h. es muss mit oberflächennahem Abtrag von Rahmen- und Filterhaltermaterial gerechnet werden. Metallkontaminationen auf dem Substratwafer könnten die unerwünschte Folge sein. Die Beschichtung verhindert eine solche Kontamination, wobei die Beschichtung aus einem nicht-kontaminierenden Material besteht. Welche Stoffe nicht-kontaminierend sind, ist von den Eigenschaften des verwendeten Zielsubstrats abhängig. Beispiele für geeignete Materialien umfassen Silizium oder Siliziumcarbid.

Figur 4 zeigt einen Querschnitt eines Filterrahmens zur Aufnahme eines Energiefilterchips. Der Energiefilterchip, der in Figur 4 ebenfalls gezeigt ist, kann auf verschiedene Weise in dem Rahmen befestigt sein, wie beispielsweise durch Kleben mittels eines vakuumfesten, temperaturstabilen und gut wärmeleitenden Klebers oder durch eine mechanische Feder. Figur 5 zeigt eine Draufsicht auf einen Filterrahmen zur Aufnahme eines Energiefilterelements, das in Figur 5 ebenfalls gezeigt ist. Der Filterrahmen weist ein Verschlusselement auf, durch welches der Rahmen zum Wechsel des Energiefilters geöffnet und geschlossen werden kann. Figur 6 veranschaulicht ein Beispiel für einen Einbau eines Rahmens zur Aufnahme einer Energiefilterelements in den Strahlengang eines Ionenimplanters. Gezeigt ist im oberen Teil von Figur 6 ein Querschnitt durch die Kammerwand und den daran angeordneten Filterhalter. In dem Beispiel ist der Filterhalter an der Innenseite der Kammerwand angeordnet, also der Seite, die bei der Implantation dem Wafer (nicht dargestellt) zugewandt ist. Der während der Implantation durch die Öffnung in der Kammerwand und das vor der Öffnung angeordnete Filter tretende Ionenstrahl ist in Figur 6 ebenfalls schematisch dargestellt. Der in den Filterhalter eingeschobene Rahmen mit dem Filterchip überdeckt die Öffnung der Kammerwand, durch die während der Implantation der Ionenstrahl tritt. Dies ist im unteren Teil der Figur 6 dargestellt, die eine Draufsicht auf die Kammerwand mit dem daran befestigen Filterhalter zeigt.

Der Rahmen kann aus demselben Material wie das Filter bestehen. In diesem Fall kann der Rahmen monolithisch mit dem Filter hergestellt werden und als monolithischer Rahmen bezeichnet werden. Wie oben erläutert kann der Rahmen auch aus einem anderen Material wie das Filter, wie beispielsweise aus einem Metall bestehen. In diesem Fall kann das Filter in den Rahmen eingesetzt werden. Gemäß einem weiteren Beispiel umfasst der Rahmen einen monolithischen Rahmen und wenigstens einen weiteren Rahmen aus einem anderen Material als das Filter, der an dem monolithischen Rahmen befestigt ist. Dieser weitere Rahmen ist beispielsweise ein Metallrahmen.

Der Rahmen kann das Filter vollständig umgeben, wie oben erläutert und gezeigt ist und wie rechts in Figur 7 gezeigt ist. Gemäß weiteren Beispielen, grenzt der Rahmen nicht an alle (vier) Seiten (Kanten) des Filters an, sondern grenzt nur an drei, zwei (gegenüberliegende) oder nur an eine der Kanten des Filters an. Unter Rahmen ist im Zusammenhang mit dieser Beschreibung also ein Vollrahmen, der das Filter an den Seiten (Kanten) vollständig umgibt, aber auch ein Teilrahmen, der das Filter an den Seiten nur teilweise umgibt, zu verstehen. Beispiele solcher Teilrahmen sind in Figur 7 ebenfalls dargestellt. Figur 7 zeigt also verschiedene Teilrahmen (links in der Abbildung) und einen Vollrahmen (ganz rechts in der Abbildung). Diese Rahmen können jeweils aus dem gleichen (z.B. monolithisch) und/oder aus einem anderen Material als der Energiefilter bestehen können.

Das Energiefilter oder jegliches andere Streuelement kann durch seinen Rahmen, der gemäß einem der oben erläuterten Beispiele realisiert sein kann, kann auf verschiedene Weise im Strahlengang des Implanter befestigt werden. Das oben erläuterte Einschieben des Rahmens in einen Filterhalter ist nur eine von mehreren Möglichkeiten. Weitere Möglichkeiten sind unten erläutert.

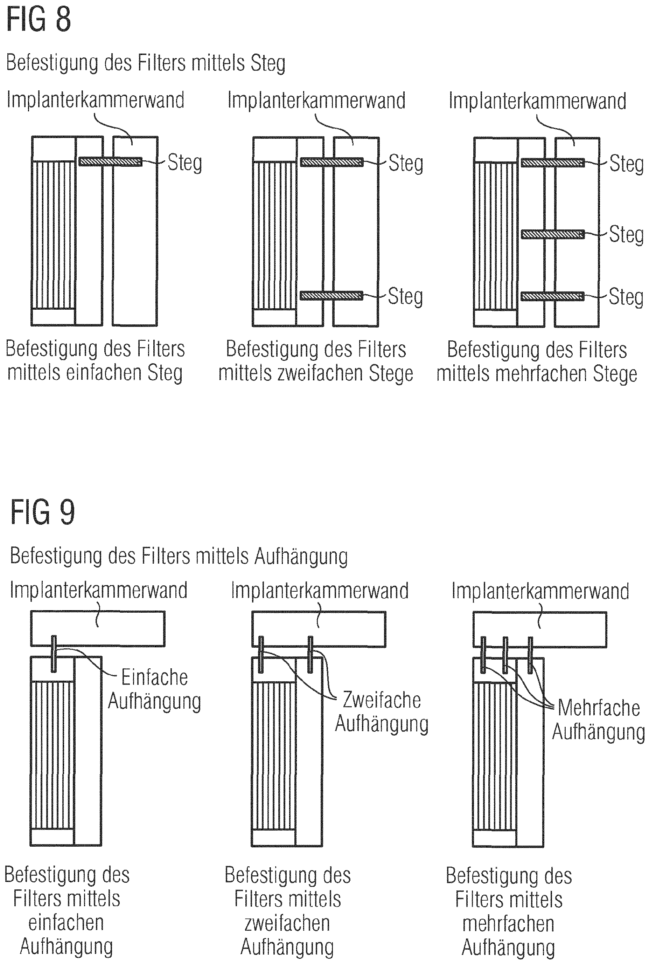

Gemäß einem Beispiel, das in Figur 8 dargestellt ist, kann der Rahmen durch wenigstens einen Steg an der Kammerwand befestigt werden. In diesem Fall dient der wenigstens eine Steg als Filterhalter. Dargestellt sind in Figur 8 Beispiele für Befestigungen mit nur einem Steg, mit zwei Stegen und mit drei Stegen. Selbstverständlich können auch mehr als drei Stege sorgesehen werden.

Gemäß einem weiteren Beispiel, das in Figur 9 dargestellt ist, kann der Rahmen auch durch Aufhängungen bzw. Aufhängungselemente an der Kammerwand befestigt werden. Diese Aufhängungselemente sind beispielsweise biegsam und können derart zwischen den Rahmen und Kammerwand gespannt werden, dass der Rahmen fest gehalten ist. Die Aufhängungselemente wirken bei diesem Beispiel als Filterhalter. Dargestellt sind in Figur 9 Beispiele für Befestigungen mit nur einer Aufhängung, mit zwei Aufhängungen und mit drei Aufhängungen. Selbstverständlich können auch mehr als drei Aufhängungen sorgesehen werden.

Gemäß einem weiteren Beispiel, das in Figur 10 dargestellt ist, wird der Rahmen mit dem Filter durch Magnete schwebend (berührungslos) gehalten. Hierzu sind an einer Vorder- und einer Rückseite des Rahmens und der Kammerwand Magnete derart befestigt, dass jeweils ein Magnet an der Kammerwand oder einem an der Kammerwand befestigten Halter einem Magnet an dem Rahmen gegenüberliegt, wobei jeweils entgegengesetzte Pole der gegenüberliegenden Magnete einander zugewandt sind. Durch die Magnetkräfte wird der Rahmen schwebend zwischen den an der Kammerwand bzw. dem Halter befestigten Magneten gehalten. Die Magnete an dem Rahmen des Filters können beispielsweise durch thermisches Aufdampfen oder jegliches anderes schichtaufbringende Verfahren realisiert werden.

### Ad 2. Beliebige vertikale Profilformen

Im Prinzip kann durch die geometrische Ausgestaltung eines Energiefilters für Ionenimplantationsanlagen die Realisierung jedes beliebigen Dotierprofils in einem Halbleitermaterial erreicht werden. Für komplexe Profile bedeutet dies, die Herstellung von geometrisch sehr anspruchsvollen dreidimensionalen geätzten unterschiedlich großen, ggfs. unterschiedlich hohen Strukturen, wie etwa Pyramiden, Gräben mit definierter Wandneigung, umgekehrte Pyramiden etc. auf dem gleichen Filterchip erforderlich ist.

Es wird vorgeschlagen beliebige Profile durch rechteckige Profilformen, wie sie mit einfachen dreiecksförmigen Strukturen erzeugt werden können, zu approximieren (Multifilter). Gegebenenfalls können auch nicht-dreiecksförmige Strukturen (z.B. Pyramiden) als Basiselemente zur Approximation verwendet werden.

D.h. es wird vorgeschlagen ein beliebiges Dotierprofil z.B. in Kastenprofile zu zerlegen und für jedes Kastenprofil eine dreiecksförmige Filterstruktur herzustellen. Anschließend werden die einzelnen Filterchips beispielsweise in dem in Abb. 6.5.1 gezeigten Rahmen derart montiert, dass die flächenmäßige Wichtung der jeweils für das Kastenprofilelement entsprechenden Dotierkonzentration entspricht, siehe Abb. 6.5.4.

Die Zerlegung eines Dotiertiefenprofils ist nicht auf die hier gezeigten Dreiecksstrukturen begrenzt, sondern es können weitere Strukturen, welche im allgemeinsten Fall Schrägen oder auch konvexe oder konkave ansteigende Flanken enthalten. Die Flanken müssen nicht notwendigerweise monoton steigend sein, sondern können auch Täler und Senken enthalten. Binäre Strukturen mit Flankenwinkeln von 90° sind auch denkbar.

Bei einem Beispiel werden die Filterelemente "schräg" ausgeschnitten und direkt nebeneinander angeordnet. Das schräge Anschneiden hat den Vorteil, dass keine Klebeverbindung zwischen den Filtern benötigt wird um Ionen am Filterrand abzublocken. Außerdem kann auf diese Weise die bestrahlte Fläche optimal genutzt werden. Bei gleichen Gesamtfilterabmessungen und gegebenem Ionenstrom erhöht dies den Waferdurchsatz.

Figur 11 veranschaulicht ein Beispiel für eine einfache Realisierung eines Multifilters. In dem Beispiel sind drei unterschiedlich ausgeformte Filterelemente in einem Rahmen der Filterhalterung zu einem ganzen Energiefilter zusammengefasst. Links oben ist in Figur 11 ein Querschnitt durch den Filterhalter mit den drei Filterelementen gezeigt und links unten ist in Figur 11 eine Draufsicht auf den Filterhalter mit den drei Filterelementen gezeigt. Rechts ist in Figur 11 ein Filterprofil gezeigt, das mit dem kombinierten Filter erreicht werden kann. Bei Verwendung dieses Filters als Implantationsfilter überstreicht der Ionenstrahl alle Einzelfilterelemente gleichmäßig, so dass das rechts in Figur 11 gezeigte Dotierstofftiefenprofil erreicht wird. Dieses Profil enthält drei Teilprofile, die mit 1, 2 und 3 nummeriert sind. Jedes dieser Teilprofile resultiert aus einem der drei links dargestellten Teilfilter, und zwar aus dem mit der entsprechenden Nummer versehenen Teilfilter.

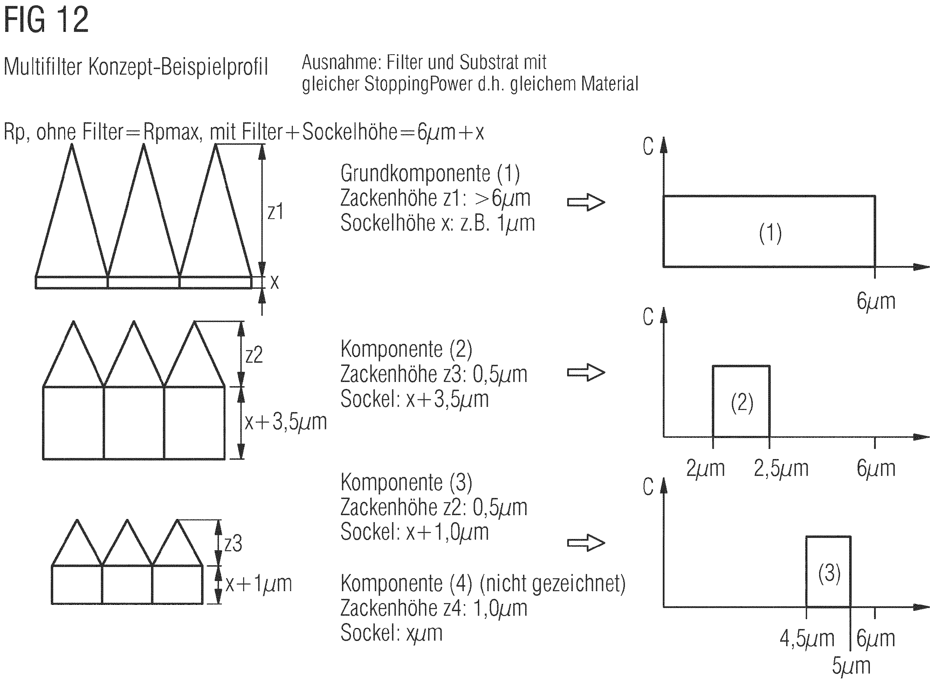

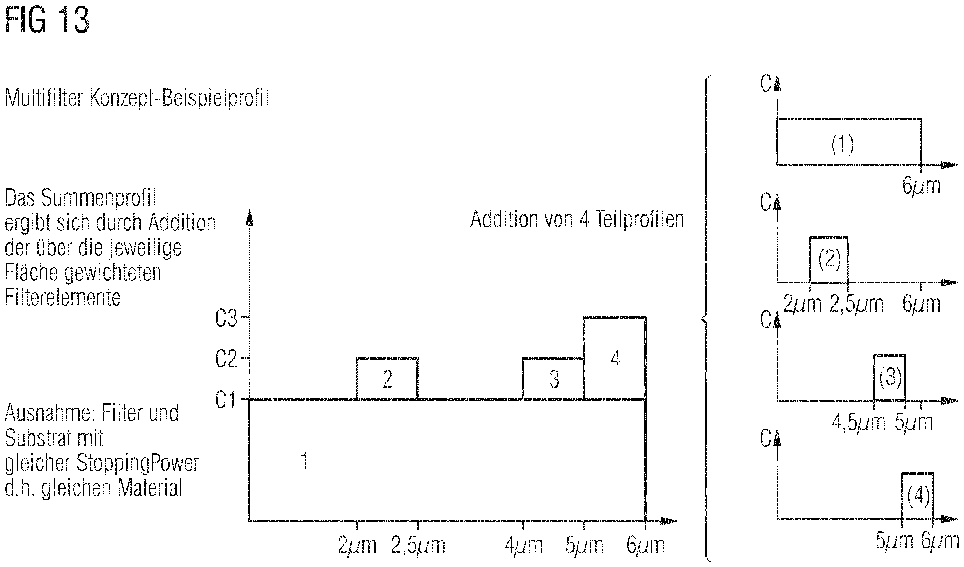

Figur 12 veranschaulicht beispielhaft die Funktionsweise von drei verschiedenen Filterelementen, die zu einem Multifilter kombiniert werden können. Figur veranschaulicht jeweils einen Querschnitt durch die einzelnen Filterelemente, beispielhafte Abmessungen dieser Filterelemente und durch Dotierstoffprofile, wie sie durch die einzelnen Filterelemente erreicht werden können. Für ein viertes, nicht dargestelltes Filterelement sind in Figur 12 nur beispielhafte Abmessungen angegeben. Die Wichtung, d.h. die resultierende Konzentration bzw. das Dotierprofil ist durch die Dimensionierung der Flächen der einzelnen Filterelemente justierbar. Für das Beispiel wurde angenommen, dass Filter und Substrat das gleiche energieabhängige Abbremsvermögen besitzen, was allerdings nicht der Fall sein muss. Figur 13 zeigt ein Beispiel eines Dotierprofils, das erhalten werden kann, wenn die vier anhand von Figur 12 erläuterten Filterelemente zu einem Multifilter kombiniert und zur Implantation verwendet werden. Dieses Summenprofil ergibt sich durch Addition der über die jeweilige Fläche gewichteten Filterelemente. Für die Darstellung wird angenommen, dass die anhand von Figur 12 beschriebenen Filterelemente mit geeigneter Wichtung zu einem Gesamtfilter zusammenmontiert und gleichmäßig von einem Ionenstrahl geeigneter Primärenergie überstrichen wurden, so dass sich das dargestellte Summenprofil ergibt.

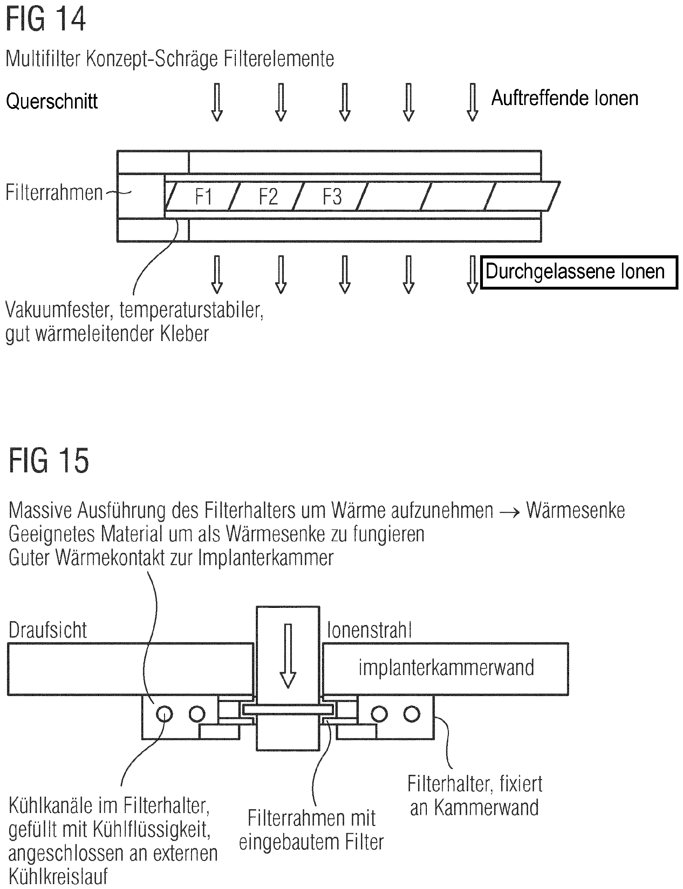

In dem anhand von Figur 11 erläuterten Beispiel sind die einzelnen Filterelemente des Multifilters durch Stege des Rahmens voneinander getrennt. Gemäß einem weiteren Beispiel, das in Figur 14 gezeigt ist, können die einzelnen Filterelemente auch direkt aneinander angrenzen. Figur 14 zeigt einen Querschnitt durch ein Multifilter, das mehrere aneinander angrenzende Filterelemente Fl, F2, F3 aufweist und das in einen Filterrahmen eingesetzt ist. Die einzelnen Filterelemente Fl, F2, F3 sind in dem Beispiel schräg angesägt und direkt aneinandergrenzend angeordnet.

### Ad 3. Hoher Durchsatz -Kühlsysteme in Kombination mit Filterbewegung

Hoher Durchsatz an Wafern ist bei gegebenen Zieldotierungen nur durch hohe Ionenströme zu realisieren. Da zwischen ca. 20% bis ca. 99% der Primärenergie des Ionenstrahls in der Filtermembran, d.h. dem durchstrahlten Teil des Implantationsfilter deponiert werden, wird der Einsatz eines Kühlverfahrens vorgeschlagen, um dadurch ein übermäßiges Ansteigen der Temperatur des Filters auch bei hohen Ionenströmen zu verhindern.

Eine solche Kühlung kann beispielsweise durch eine oder mehrere der nachfolgend unter a. bis c. erläuterten Maßnahmen erfolgen:

### a. Kühlmitteldurchfluss in der Filterhalterung.

Hierdurch wird der erhitzte Filterchip durch Ableitung der Wärme gekühlt. Figur 15 zeigt ein Beispiel einer solchen gekühlten Filterhalterung. Gezeigt ist insbesondere ein Querschnitt einer Filterhalterung, die an einer Kammerwand eines Implanters befestigt ist. In dem dargestellten Beispiel sind in dem Filterhalter, welcher den Filterrahmen aufnimmt, sind Kühlleitungen integriert, welche durch ein externes Kühlgerät (nicht dargestellt) mit Kühlflüssigkeit versorgt werden. Alternativ oder zusätzlich können die Kühlleitungen auch auf der Oberfläche des Filterhalters angeordnet sein (nicht dargestellt).

### b. Bewegung des Filters oder Ionenstrahls

Es wird vorgeschlagen bei Verwendung eines rotierenden, beispielsweise mit 10-15 Wafern beladenen Waferrades, den Filter bzw. den Halter des Filters derart zu gestalten, dass er rotiert oder mit einer Linearbewegung pendelt. Alternativ kann der Ionenstrahl bei fest stehendem Filter elektrostatisch über den Filter bewegt werden.

Bei diesen Ausführungsvarianten wird das Filter pro Zeiteinheit nur teilweise durch den Ionenstrahl bestrahlt. Dadurch kann der aktuell nicht bestrahlte Teil des Filters über Strahlungskühlung. Somit können im Dauereinsatz gemittelte höhere Stromdichten bei gegebenem Filter realisiert werden. Beispiele, wie dies realisiert werden kann, sind in den Figuren 16 und 17 gezeigt.

Figur 17 veranschaulicht ein Energiefilter mit relativ großer Fläche, welcher pro Zeiteinheit nur partiell bestrahlt wird. Somit können die nicht bestrahlten Bereiche über Strahlungskühlung abkühlen. Diese Ausführungsform ist auch als Multifilter gestaltbar, wie es oben beschrieben wurde. D.h. als Filter, das mehrere unterschiedliche Filterelemente aufweist. In dem dargestellten Beispiel pendelt der Rahmen mit dem Filter in einer Richtung senkrecht zur Strahlrichtung des Ionenstrahls, der schematisch dargestellt ist. Die von dem Ionenstrahl überdeckte Fläche des Filters ist geringer als die Gesamtfläche des Filters, so dass pro Zeiteinheit nur ein Teil des Filters durchstrahlt wird. Dieser Teil ändert sich stetig aufgrund der Pendelbewegung.

Figur 18 zeigt ein Beispiel einer Filteranordnung mit mehreren Filterelementen, die durch einen rotierenden Filterhalter gehalten werden. Die einzelnen Filterelemente können jeweils gleich strukturiert sein, können aber auch unterschiedlich strukturiert sein, um ein Multifilter zu erhalten. Wie in Figur 18 gezeigt ist, bewegen sich die einzelnen Filterelemente bei Rotation des Halters auf einer Kreisbahn um die Rotationsachse (zentrale Achse) des Halters. Auch bei diesen Beispiel wird pro Zeiteinheit nur partiell bestrahlt, d.h., es werden nicht alle Filterelemente gleichzeitig bestrahlt, so dass die nicht bestrahlten Filterelemente abkühlen können.

### Ad 4. Vereinfachtes Filterdesign

Die Herstellung von Zackenstrukturen des Filters mit exakter Höhe und perfekter Spitze der Filterelemente ist prozesstechnisch anspruchsvoll und dementsprechend teuer.

Für einfache Dotierverläufe (z.B. homogene Dotierung), die von der Substratoberfläche starten und die lediglich eine einfache Zackenstruktur benötigen soll hier eine vereinfachtes Design und damit einhergehend eine vereinfachte Herstellung vorgeschlagen werden.

Es wird vorgeschlagen, statt einer Spitze die mikrostrukturierte Membran (z.B. Zackenstruktur) des Filters mit einem Plateau auf den Zacken auszugestalten und die Dicke der Stützschicht der Membran so zu dimensionieren, dass der entstehende niederenergetische Dotierstoffpeak in die Stützschicht des Filters geschoben wird und somit nicht in das Substrat implantiert wird. Ein Beispiel eines solchen Filters ist in Figur 18 gezeigt. Dargestellt ist ein Querschnitt (links in der Figur), eine Draufsicht (in der Mitte) und ein Beispiel eines Dotierprofils, das durch das dargestellte Filter erreicht werden kann. Wie dargestellt ist, kann durch Implantation von Ionen in das Energiefilter mit Hilfe einer trapezprismenförmigen Struktur ein Rechteckprofil im Substrat erzeugt werden. Der anfängliche Peak wird in das Energiefilter implantiert, d.h. innerhalb des Substrats ist kein Peak des Dotierprofils vorhanden.. Das Implantationsprofil hat die vorteilhafte Eigenschaft, dass es direkt an der Substratoberfläche beginnt, was für die Applikation des Energiefilters von entscheidender Bedeutung sein kann.

Wie anhand des Querschnitts des Filters in Figur 18 ersichtlich ist, sind weist diese Filtterstruktur Plateaus statt Zacken auf, die einzelnen Strukturelemente sind im Querschnitt also trapezförmig. Damit wird die prozesstechnische Realisierung des Filters wesentlich vereinfacht. Es ist bekannt dreieckförmige Strukturen in Silizium beispielsweise durch nasschemisches Ätzen mittels KOH oder TMAH herzustellen. Dafür ist die lithographische Abdeckung der Dreiecksspitzen notwendig. Sollen perfekte Spitzen hergestellt werden führt das zum Problem der Unterätzung der Lack- bzw. Hartmaskenstruktur. Dieses Problem kann ohne die hier vorgeschlagene Idee nur durch perfekte (und somit aufwändige, kostenintensive) Prozessierung gelöst werden. Die hier vorgeschlagene Idee, vereinfacht somit die Herstellung der Filterstrukturen ganz wesentlich. Dies gilt analog auch für moderne plasmagestützte Ätzverfahren, wie etwa RIBE oder CAIBE.

### Ad 5. Hohe Laterale Homogenität des erzeugten Dotier- bzw. Defektgebietes

Der Aspekt der lateralen Homogenität kann bei statischen Implantationssituationen wesentlich sein. Im Falle der Verwendung einer rotierenden Waferdisk (Waferrad) mit beispielsweise 11 Wafern und feststehendem Ionenstrahl wird die Homogenität durch die Rotations- und Translationsbewegung der Waferdisk relativ zum Ionenstrahl bestimmt.

Filter-Substrat Abstand: Die Winkelverteilung der transmittierten Ionen ist energieabhängig. Sind Filter und Energie der Ionen so aufeinander abgestimmt, dass u.a. sehr niederenergetische Ionen (nukleares Abbremsregime) den Filter verlassen, so ist die Breite der Winkelverteilung groß, da Großwinkelstreuereignisse häufig vorkommen. Sind Filter und Energie der Ionen so aufeinander abgestimmt, dass nur hochenergetische Ionen (nur im elektronischen Regime, dE/dxₑₗₑₖₜₒₙ > dE/dxₙᵤₖₗₑₐᵣ) den Filter verlassen, so ist die Winkelverteilung sehr schmal.

Ein minimaler Abstand ist dadurch charakterisiert, dass die Struktur des Filters nicht in das Substrat übertragen wird, d.h. z.B. dass bei gegebenem Streuwinkelverteilung der transmittierten Ionen, diese wenigstens eine laterale Distanz vergleichbar mit der Periode der Gitterkonstante des Ionenfilters überstreichen.

Ein maximaler Abstand ist bestimmt durch den bei einer gegebenen Streuwinkelverteilung von der Applikation (Halbleiterbauelement) noch zu tolerierende Verlust durch gestreute Ionen, insbesondere am Rand des Halbleiterwafers.

Figur 19 zeigt das das Ergebnis eines Versuches, bei dem Ionen durch einen Energiefilter während einer statischen Implantation in ein PMMA-(Polymethylacrylat)-Substrat implantiert wurden. Die Ionen zerstören hierbei die Molekülstruktur des PMMA, so dass ein anschließender Entwicklungsprozess, die Energieverteilung der Ionen derart offenlegt, dass Bereiche hoher Energiedeposition aufgelöst werden. Bereiche geringer oder ohne Energiedeposition durch Ionen werden in der Entwicklerlösung nicht aufgelöst.

Die hier vorgeschlagene Idee ist es, bei korrekter Wahl des Filter-Substrat-Abstandes sowohl für dynamische als auch für statische Implantationsanordnungen eine hohe laterale Dotierhomogenität zu erzeugen.

### Ad 6. Überwachung des "End of Life" für den Energiefilter

Aufgrund der nuklearen Wechselwirkung und der hohen Temperaturwechsel (Erwärmung des Filters typischerweise auf einige 100°C) degradieren Energiefilter als Funktion der akkumulierten implantierten Ionendosis.

Ab einer kritischen Ionendosis, wird das Filter in seiner chemischen Zusammensetzung, seiner Dichte und seiner Geometrie derart verändert, dass die Auswirkungen auf das zu realisierende Zielprofil nicht mehr vernachlässigt werden können. Die kritische Ionendosis ist abhängig vom verwendeten Filtermaterial, der implantierten Ionensorte, der Energie, der Geometrie und der erlaubten Schwankungsbreite (=Spezifikation) des Zielprofils.

Für jeden Filterimplantationsprozess mit gegebener Energie, Ionensorte, Profil etc. kann daher eine Spezifikation, welche eine Maximaltemperatur während der Implantation und eine maximale erlaubte akkumulierte Ionendosis beinhaltet, definiert werden. Gemäß einem Beispiel ist vorgesehen, die Verwendung des Energiefilters derart zu überwachen, dass eine Verwendung außerhalb der Spezifikation, auch ohne die Überwachung durch einen Ingenieur, nicht erfolgen kann. Hierzu wird vorgeschlagen, jeden Filter mit einer elektronisch auslesbaren Signatur zu erfassen, sobald das Filter in die Filterhalterung am Implanter eingesetzt wird und diese Signatur auszulesen, beispielsweise durch einen Steuerrechner. Die Signatur ist hierzu beispielsweise in einem elektronisch auslesbaren, an dem Filter angeordneten Speicher abgespeichert. In einer Datenbank sind beispielsweise die Signaturen der an einem bestimmten Implanter einsetzbaren Filter und deren Eigenschaften abgespeichert, wie beispielsweise für welchen Prozess (Ionensorte, Energie) das Filter geeignet ist und welche akkumulierte Dosis, sowie welche maximale Temperatur erreicht werden dürfen. Durch Abgleich der ausgelesenen Signatur mit der Datenbank kann durch den Steuerrechner somit festgestellt werden, ob das Filter für eine geplanten Implantationsprozess geeignet ist.

Figur 20 veranschaulicht ein Kontrollsystem zur Identifikation des Filters und zur Überwachung der Einhaltung der Filterspezifikation (Maximaltemperatur, maximale akkumulierte Ionendosis). Ist das Filter identifiziert wird durch die eingebauten Sensoren (Ladungsintegrator und Temperatursensor) beispielsweise permanent die akkumulierte Ionendosis und die Temperatur des Filters gemessen. Der Implantationsprozess wird beendet, wenn einer der spezifizierten Parameter erreicht bzw. überschritten wird, wenn das Filter also beispielsweise zu heiß wird oder die erlaubte Maximaldosis durch den Filter implantiert wurde. D.h., bei Verletzung der Spezifikation wird ein Signal an den Steuerrechner gesendet, welcher den Implantationsvorgang beendet.

### Ad 7. Einschränkung der Winkelverteilung der transmittierten Ionen

Für Anwendungen, welche auf dem Zielsubstrat ausgesparte Bereiche erfordern, kann eine Maskierung auf dem Zielsubstrat aufgebracht werden.

Um eine laterale "Aufweichung" der Strukturen, durch eine filterinduzierte zu breite Ionenverteilung zu vermeiden, wird vorgeschlagen den durch den Filter transmittierten Ionenstrahl zu kollimieren. Die Kollimation kann durch streifen-, röhren-, gitter- oder hexagonal gestaltete Strukturen mit hohen Aspektverhältnissen erfolgen, welche im transmittierten Strahl nach dem Energiefilter platziert werden. Das Aspektverhältnis dieser Strukturen definiert den erlaubten maximalen Winkel.

Verschiedene Beispiele sind in den Figuren 21 bis 25 dargestellt. Figur 21 zeigt einen Querschnitt einer Implanterkammerwand im Bereich der Strahlöffnung, eines an der Kammerwand befestigten Filterhalters mit einem eingesetzten Filter und eines Kollimators, der in dem Beispiel an einer der Kammerwand abgewandten Seite des Filterhalters befestigt ist. Ein Aspektverhältnis des Kollimators, das bestimmt ist durch die Länge und die Breite des Kollimators, bestimmt den maximalen Winkel α relativ zur Längsrichtung des Kollimators unter dem der Ionenstrahl in den Kollimator eingestrahlt werden kann, um den Kollimator zu passieren. Anteile des Ionenstrahls, die unter größeren Winkeln eingestrahlt werden, enden an der Wand des Kollimators, passieren diesen also nicht. Sollte der zur Verfügung stehende Abstand zwischen dem Filter und dem Substrat, in das implantiert werden soll, für ein gewünschtes Aspektverhältnis nicht ausreichen, so kann der Kollimator auch aus mehreren nebeneinander angeordneten Kollimatoreinheiten mit kleinerer Öffnung bestehen. Diese können z.B. wabenförmig angeordnet sein.

Alternativ kann die Kollimatorstruktur auch direkt auf dem Filterelement angeordnet sein. Die Herstellung eines solchen Elements kann monolithisch erfolgen oder durch Mikrobondverfahren. Zwei Beispiele einer solchen direkt auf dem Filter angeordneten Kollimatorstruktur sind in Figur 22 gezeigt. Eine solche direkt auf dem Filter angeordnete Kollimatorstruktur kann das Filter mechanisch stabilisieren und auch kühlend wirken, da die Kollimatorstruktur als Kühlkörper mit einer im Vergleich zu dem Filter größeren Oberfläche wirken kann. Der maximale Winkel α wird auch hier durch das Aspektverhältnis der einzelnen auf dem Filter angeordneten Kollimatorstrukturen definiert, die jeweils eine Länge und eine Breite aufweisen. Die Kollimatorstruktur kann beispielsweise durch Kleben, Bonden, oder ähnliches an dem Filter befestigt werden.

Bei dem in Figur 22 gezeigten Beispiel ist die Kollimatorstruktur auf der strukturierten Seite des Filters angeordnet, also dort wo das Filter Erhebungen und Vertiefungen aufweist. Die Strukturen sind bei diesem Beispiel trapezförmig. Figur 23 zeigt eine Abwandlung der Anordnung von Figur 22. Bei diesem Beispiel ist die Kollimatorstruktur auf der unstrukturierten Seite des Filters angeordnet. In beiden Fällen ist die Kollimatorstruktur in Strahlrichtung des Ionenstrahls (die in den Figuren 21 und 22 durch den Pfeil symbolisiert ist) nach dem Filter angeordnet, also so, dass der Ionenstrahl die Kollimatorstruktur nach dem Passieren des Filters passiert.

Figur 24 zeigt Draufsichten auf Kollimatorstrukturen gemäß verschiedener Beispiele. Diese Kollimatorstruktur ist in den dargestellten Beispielen auf einem Filter angeordnet, das in Draufsicht eine lamellenartige Struktur besitzt. Die einzelnen "Filterlamellen" können im Querschnitt beispielsweise dreieckförmig oder trapezförmig sein, so wie dies zuvor erläutert wurde. Eine lamellenartige Struktur des Filters ist aber nur ein Beispiel. Beliebige andere Filterstrukturen, wie sie zuvor erläutert wurden, können ebenfalls verwendet werden. Im linken Teil und in der Mitte zeigt Figur 24 je ein Beispiel, bei dem die Kollimatorstruktur streifenförmig ausgebildet ist, also mehrere parallele Streifen aufweist, die sich jeweils über die gesamte Breite des Filters erstrecken. Durch je zwei benachbarte Streifen ist ein Kollimator gebildet, wobei die Breite dieses Kollimators durch den Abstand der benachbarten Streifen bestimmt ist. Die Länge des Kollimators ist durch die Höhe der einzelnen Streifen bestimmt. Die "Höhe" der Streifen ist deren Abmessung in einer Richtung senkrecht zur Zeichenebene. Die Streifen der Kollimatorstruktur können senkrecht zu den Lamellen des Filters verlaufen, wie links in Figur 24 dargestellt ist, oder können parallel zu den Lamellen verlaufen, wie in der Mitte dargestellt ist. Rechts ist in Figur 24 ein Beispiel gezeigt, bei dem die Kollimatorstruktur in Draufsicht gitterförmig, wodurch eine Vielzahl von Kollimatoren gebildet sind, deren Geometrie durch die Geometrie des Gitters bestimmt ist. In dem dargestellten Beispiel sind die einzelnen Kollimatoren in Draufsicht rechteckig, insbesondere quadratisch, so dass die Kollimatoren rechteckförmige Röhren sind. Dies ist aber nur ein Beispiel, das Gitter kann auch so realisiert werden, dass die einzelnen Kollimatoren in Draufsicht kreisförmig, elliptisch oder sechseckig (wabenförmig) sind oder eine beliebige andere polygonale Geometrie haben.

### Kollimation durch Hartmaske auf dem Zielsubstrat

Für maskierte Implantationen kann alternativ oder zusätzlich zu einem Kollimators auf dem Filter eine als Kollimatorstruktur wirkende Maskierung auf dem Zielwafer aufgebracht werden. Eine Bedingung an diese Maskierung kann lauten, dass das Abbremsvermögen der Maskierung mindestens der mittleren Reichweite des transmittierten Ionenstrahls im Zielsubstratmaterial entspricht muss. Um durch die Maskierung zusätzlich noch die erforderliche Einschränkung der Winkelverteilung zu leisten, kann das Aspektverhältnis der Maskierung entsprechend angepasst werden. Figur 25 zeigt ein Beispiel einer solchen Kollimatorstruktur, die direkt auf dem Zielsubstrat angeordnet ist. Diese Kollimatorstruktur kann eine beliebige der zuvor erläuterten Geometrien aufweisen, kann also beispielsweise lamellenförmig, streifenförmig, röhrenartig oder wabenförmig aufgebaut sein - je nach Layout der Substratstruktur und der benötigten maximalen Winkelverteilung. Das Aspektverhältnis dieser Kollimatorstruktur ist das Verhältnis von Höhe (h in Figur 25) zu Breite (b in Figur 25) der Aussparungen der die Kollimatorstruktur bildenden Maske auf dem Substrat.

Es hat sich gezeigt, dass die Kollimatorstruktur nicht nur die Streuung in lateraler Richtung, sondern auch das Tiefenprofil beeinfluss. Diese ist in Figur 26 gezeigt, die die die Dotierprofile für drei verschiedene Implantationsverfahren zeigt, die jeweils mit demselben Filter, aber verschiedenen Kollimatorstrukturen durchgeführt wurden. Das Filter hat in dem Beispiel jeweils eine lamellenartige Struktur mit einem trapezförmigen Querschnitt. Dies ist aber lediglich ein Beispiel. Im linken Teil der Figur ist ein Implantationsverfahren veranschaulicht, bei dem ohne Kollimatorstruktur implantiert wird. Das dadurch erhaltene Implantationsprofil beginnt an der Oberfläche des Substrats.

In der Mitte und rechts sind in Figur 26 Implantationsverfahren veranschaulicht, bei denen mit Kollimatorstruktur implantiert wir, wobei das Aspektverhältnis der Kollimatorstruktur bei dem rechts dargestellten Beispiel höher als bei dem in der Mitte dargestellten Beispiel ist. Wie zu sehen ist, beginnen die durch diese Implantationsverfahren erhaltenen Dotierprofile nicht an der Oberfläche des Substrats sondern beabstandet dazu, wobei die Dotierprofile umso weiter zu der Oberfläche beabstandet sind und umso flacher ansteigen, je größer das Aspektverhältnis ist. Dies kann dadurch erklärt werden, dass das Dotierstoffprofil im oberflächennahen Bereich des Substrats durch Ionen verursacht wird, die im Filter stärker abgebremst werden, und dadurch eine niedrigere Energie besitzen. Solche Ionen mit niedriger Energie werden durch das Filter stärker gestreut, als Ionen mit höherer Energie, so dass diese Ionen mit niedriger Energie eine größere Winkelverteilung besitzen als Ionen mit höherer Energie. Dadurch gelangen mehr Ionen mit niedriger Energie als Ionen mit höherer Energie nicht mehr durch die Kollimatorstruktur, wobei dieser Effekt umso ausgeprägter ist, je größer das Aspektverhältnis der Kollimatorstruktur ist, je kleiner also der maximale Winkel sein darf, bei dem die Ionen die Kollimatorstruktur noch passieren können.

Um trotz Kollimatorstruktur ein an der Oberfläche beginnendes, annähernd homogenes Dotierprofil erzeugen zu können, kann das Filter so gestaltet werden, dass Ionen mit niedriger Energie "bevorzugt" werden, dass also mehr Ionen mit niedriger Energie als Ionen mit höherer Energie das Filter passieren. Ein Beispiel eines solchen Filters ist in Figur 27 gezeigt. Bei diesem Beispiel besitzt das Filter unterschiedliche Filterbereiche, die jeweils eine maximale und eine minimale Dicke besitzen. Die maximale Dicke ist in allen drei Bereichen gleich, die minimale Dicke ist jedoch unterschiedlich. Dies wird in dem Beispiel dadurch erreicht, dass das Filter in den einzelnen Bereichen jeweils eine auf einem Sockelbereich angeordnete trapezförmige Struktur besitzen, wobei die Höhe des Sockels unterschiedlich dick ist bzw. die trapezförmigen Strukturen unterschiedlich hoch sind. In einem ersten Abschnitt ist die Dicke des Sockels am geringsten und die trapezförmige Struktur am höchsten, wodurch ein Abstand CD1 zwischen benachbarten Strukturen in diesem Abschnitt am größten ist. In einem dritten Abschnitt ist die Dicke des Sockels am größten und die trapezförmige Struktur am niedrigsten, wodurch ein Abstand CD3 zwischen benachbarten Strukturen in diesem Abschnitt am kleinsten ist. In einem zweiten Abschnitt liegt die Dicke des Sockels zwischen der Dicke im ersten Abschnitt und der Dicke im dritten Abschnitt, entsprechend ist eine Höhe der trapezförmigen Struktur in diesem Abschnitt zwischen der Höhe im ersten Abschnitt und im dritten Abschnitt und ein Abstand CD2 zwischen benachbarten Strukturen ist in diesem Abschnitt zwischen dem Abstand CD1 im ersten Abschnitt und dem Abstand CD3 im dritten Abschnitt. Die einzelnen Abschnitte können bezogen auf Ihre Fläche jeweils gleich groß sein, können aber auch unterschiedlich groß sein. Darüber hinaus können selbstverständlich auch mehr als drei Abschnitte mit unterschiedlichen minimalen Filterdicken vorgesehen werden.

Figur 27 zeigt im linken Teil ein Implantationsprofil, das bei Implantation mit dem beschriebenen Filter erhalten wir, wenn ohne Kollimatorstruktur implantiert wird. Dieses Implantationsprofil beginnt an der Oberfläche, die Dotierkonzentration nimmt aber stufenförmig mit zunehmender Tiefe ab. In dieser Figur bezeichnet CD1 einen Bereich des Dotierprofils, der durch den ersten Abschnitt des Filters hervorgerufen wird, CD2 bezeichnet einen Bereich des Dotierprofils, der durch den zweiten Abschnitt des Filters hervorgerufen wird, und CD3 bezeichnet einen Bereich des Dotierprofils, der durch den dritten Abschnitt des Filters hervorgerufen wird. Anhand des Dotierprofils ist ersichtlich, dass die den jeweiligen Filterbereich passierenden Ionen umso weniger tief in das Substrat eindringen, dass deren Energie also umso geringer ist, je größer die minimale Dicke des Sockels des jeweiligen Abschnitts ist. Außerdem zeigt das Dotierprofil, dass durch dieses Filter mehr Ionen mit niedriger Energie als Ionen mit hoher Energie gelangen. Da, wie oben erläutert, die Ionen mit niedriger Energie allerdings stärker gestreut werden als die Ionen mit höherer Energie, und damit weniger Ionen mit niedriger Energie als Ionen mit höherer eine Kollimatorstruktur passieren, kann bei Verwendung eines solchen Filters in Verbindung mit einer Kollimatorstruktur ein annähernd homogenes und an der Oberfläche beginnendes Dotierprofil erreicht werden. Dies ist rechts in Figur 27 gezeigt, in der ein Implantationsverfahren unter Verwendung des erläuterten Filters und einer Kollimatorstruktur gezeigt ist. Die Kollimatorstruktur befindet sich in dem Beispiel auf dem Substrat, kann aber auch auf dem Filter angeordnet werden.

### Ad 8. Geringer Filterverschleiß durch Sputtereffekte

Implantationsanordnung des Filters zum Substrat, einmal Zacken zum Substrat, einmal Zacken weg vom Substrat (→ Sputtern, Streuung bei Auftreffen). Während der zuvor erläuterten und nachfolgend erläuterten Implantationsverfahren kann das Filter jeweils so verwendet werden, dass die Mikrostrukturen des Filters dem Substrat zugewandt sind, also vom Ionenstrahl weg zeigen, wie in Figur 28 (a) gezeigt ist. Alternativ kann das Filter auch gedreht werden, so dass die Mikrostrukturen des Filters vom Substrat abgewandt sind, also zum Ionenstrahl hin zeigen, wie in Figur 28 (b) gezeigt ist. Letzteres kann vorteilhafte Auswirkungen auf Sputtereffekte im Filter haben.

### Ad 9. Vermeidung von Channelingeffekten durch die Anordnung des Filters zum Ionenstrahl Verkippen des Filters und/oder des Substrates

Sofern Filter und/oder Substrat aus kristallinem Material bestehen, kann es zu unerwünschten Channelingeffekten kommen. D.h. Ionen können entlang bestimmter Kristallrichtungen eine erhöhte Reichweite erzielen. Die Größe der Effekts, sowie der Akzeptanzwinkel sind temperatur- und energieabhängig. Der Implantationswinkel, sowie die kristallographische Oberflächenorientierung des verwendeten Ausgangsmaterials für Filter und Substrat spielen eine entscheidende Rolle. Im allgemeinen kann über einen Wafer der Channelingeffekt nicht sicher reproduziert werden, da sich die o.g. Parameter von Wafer zu Wafer und von Implantationsanlage zu Implantationsanlage unterscheiden können.

Channeling sollte daher vermieden werden. Eine Verkippung von Filter und Substrat kann Channeling verhindern. Channeling im Filter bzw. im Substrat kann jeweils ganz unterschiedliche Auswirkungen auf das Tiefenprofil des implantierten Dotierstoffes habe, insbesondere wenn Filter und Substrat aus unterschiedlichen Materialien bestehen.

Figur 29 zeigt schematisch ein Filter das während des Implantationsprozesses derart gegenüber dem Substrat gekippt ist, dass eine Grundfläche des Filters mit einer Oberfläche des Substrats einen Winkel einschließt, der größer als Null ist. Dieser Winkel ist beispielsweise größer als 3°, größer als 5° oder größer als 10° und kleiner als 30°. Insbesondere dann, wenn das Energiefilter aus anisotropen Materialien gefertigt ist, kann hierdurch ein Channeling-Effekt verhindert oder reduziert werden.

### Ad 10. Realisierung komplexer Dotierstofftiefenprofile bei einfacher Filtergeometrie

Wie oben erläutert können komplexere Dotierstofftiefenprofile durch angepasste geometrische Ausgestaltung des Filterelementes realisiert werden. Zur Vereinfachung in den nachfolgenden Erläuterungen Streueffekte aller Art vernachlässigt werden.

Für den Fall gleicher Abbremsfähigkeit von Ionen (Stopping Power (dE/dx)) im Filter und im Substratmaterial können sich z.B. die in Figur 30 gezeigten Situationen ergeben. Figur 30 zeigt eine schematische Darstellung verschiedener Dotierprofile (Dotierkonzentration als Funktion der Tiefe im Substrat) für unterschiedlich geformte Energiefilter, die jeweils in Seitenansicht und Aufsicht dargestellt sind. Wie gezeigt ist, erzeugen (a) dreiecksprismenförmige Strukturen ein rechteckförmiges Dotierprofil, (b) kleinere dreiecksprismenförmige Strukturen erzeugen ein weniger tiefenverteiltes Dotierprofil als die in (a) gezeigten größeren dreiecksprismenförmigen Strukturen, (c) trapezprismenförmige Strukturen erzeugen ein rechteckförmiges Dotierprofil mit einem Peak am Profilbeginn und (d) pyramidenförmige Strukturen erzeugen ein dreiecksförmiges, in die Tiefe des Substrates ansteigendes Dotierprofil.

Beispielsweise bei Verwendung von Silizium als Substratmaterial, welches beispielsweise mit Bor dotiert werden soll, ergeben sich bei der Ausgestaltung des Energiefilters mit unterschiedliche Materialien, je nach Dichte und Verlauf von dE/dx als Funktion der aktuellen kinetischen Ionenenergie, geänderte Dotiertiefenprofile im Substrat. Ein perfekt homogener, d.h. konstanter Verlauf der Dotierung in der Tiefe wird nur bei identischen Materialien für Filter und Substrat erreicht. Dies ist in Figur 31 veranschaulicht, in der Dotierprofile in verschiedenen Substratmaterialien (Targetmaterialien) gezeigt sind, bei identischen Implantationsprozessen, d.h. Implantationsprozessen mit gleichem Primärion und gleicher Primärenergie, erhalten wurden. Das Filtermaterial war jeweils Silizium. Die Dotierprofile unterscheiden sich aufgrund der unterschiedlichen Substratmaterialien.

Figur 32 veranschaulicht den Verlauf des Abbremsvermögens als Funktion der Energie [4] (SRIM-Simulation) für die verschiedenen Substratmaterialien, die der Darstellung in Figur 31 zugrunde liegen.

Es wird nun vorgeschlagen, bei gegebener Oberflächengeometrie den energieabhängigen Verlauf des Abbremsvermögens z.B. durch Ausgestaltung des Filters als Multischichtsystem anzupassen.

Es wird vorgeschlagen den Verlauf des Abbremsvermögens als Funktion der Ionenenergie, (d.h. bei gegebener Ionensorte und Primärenergie, als Funktion des vertikalen Position in einer Filterzacke) derart zu modellieren, dass sich insgesamt (d.h. vom Eintritt des Ions in den Filter bis zur Endposition im bestrahlten Substrat) ein von der Eintrittsposition auf dem Filter (genauer gesagt von der tatsächlichen Weg des Ions durch Filter und Substrat) abhängiger Gesamtverlust an kinetischer Energie ergibt. Der Energieverlust im Filter wird damit nicht mehr nur von der durchstrahlten Länge des Filtermaterials sondern, von dem ortsabhängigen Verlauf des Abbremsvermögens bestimmt.

Somit können bei entsprechender Modellierung und beispielsweise fester Geometrie ansteigende oder in der Tiefe abfallende Dotierverläufe hergestellt werden. Das Abbremsvermögen wird somit zu einer Funktion der lateralen Position. Beispiele solcher Filter sind in den Figuren 33 bis 35 dargestellt. Die laterale Position ist in diesen Figuren jeweils mit y bezeichnet.

Figur 33 veranschaulicht ein mehrschichtiges Ausgangsmaterial für ein mehrschichtiges Filter. Dieses Ausgangsmaterial umfasst in dem Beispiel vier verschiedene Schichten, die mit 1 bis 4 bezeichnet sind. Die Verwendung von vier Schichten ist aber nur ein Beispiel. Es können auch weniger als oder mehr als vier unterschiedliche Schichten verwendet werden. Die einzelnen Schichten können sich nicht nur bezüglich des verwendeten Materials sondern auch bezüglich ihrer Dicke unterschieden. Auch ist es möglich, dass zwei Schichten das gleiche Material aufweisen und durch zwei oder mehr Schichten aus anderen Materialien getrennt sind. Die einzelnen Schichten können durch geeignete Abscheideverfahren sequentiell aufeinander abgeschieden bzw. hergestellt werden.

Bei geeigneter Ausgestaltung des Schichtstapels von Materialien mit unterschiedlichem Abbremsvermögen wird, können selbst bei einfacher Filtergeometrie komplexe Dotierstofftiefenprofile realisiert werden. Figur 34 zeigt einen Querschnitt eines Filters, das basierend auf dem in Figur 33 hergestellten Ausgangsmaterial realisiert wurde und das in dem dargestellten Beispiel einen Sockel und auf dem Sockel angeordnete dreieckförmige Strukturen aufweist. Diese dreieckförmigen Strukturen können in streifenförmig, also in einer Richtung senkrecht zur Zeichenebene langgestreckt, oder auch Teil pyramidenförmiger Strukturen sein.

Wie in Figur 35 dargestellt ist, kann das Filter auch so realisiert werden, dass mehrere Strukturen in lateraler Richtung (y-Richtung) nebeneinander angeordnet sind, die unterschiedliche Geometrien und/oder unterschiedliche Schichtstapel, d.h. Schichtstapel mit unterschiedlichem Aufbau bezüglich der Abfolge einzelner Schichten und/oder des Materials der einzelnen Schichten aufweisen. Beispielhaft sind bei dem dargestellten Filter sechs verschiedene Materialien verwendet, die mit 1-6 bezeichnet sind.

Als Materialien für die einzelnen Schichten eignen sich beispielsweise, ohne allerdings auf solche Materialien beschränkt zu sein, Silizium, Silziumverbindungen oder Metalle. Siliziumverbindungen sind beispielsweise Siliziumkarbid (SiC), Siliziumoxid (SiO₂) oder Siliziumnitrid (SiN). Geeignete Metalle sind beispielsweise Kupfer, Gold, Platin, Nickel oder Aluminium. Gemäß einem Beispiel wird wenigstens eine Schicht aus einer Siliziumverbindung auf eine Siliziumschicht aufgewachsen und auf die wenigstens eine Schicht aus einer Siliziumverbindung wird eine Metallschicht aufgedampft. Eine Metallschicht kann auch direkt auf eine Siliziumschicht aufgedampft werden. Auch besteht die Möglichkeit, verschiede Metallschichten übereinander durch Aufdampfen herzustellen, um dadurch verschieden Schichten des Filters zu erhalten.

### Ad 11. Elektronenunterdrückung

Es ist bekannt, dass bei der Transmission von Ionen durch einen Festkörper Elektronen des Primärstrahls im Festkörper verbleiben oder vom Ion aufgenommen werden, d.h. die transmittierten Ionen haben abhängig von den Eigenschaften des Filtermaterials und der Primärenergie nach Durchgang durch den Filter im Mittel einen höheren oder niedrigeren Ladungszustand [26], es werden Elektronen an den Filter abgegeben oder aufgenommen.

Figur 36 veranschaulicht die Gleichgewichtsladungszustande eines Ions (Schwarze Linie: Thomas-Fermi-Abschätzung, Blaue Linie: Monte-Carlo-Simulationen, Rote Linie: Experimentelle Ergebnisse) als Funktion der kinetischen Energie des Ions beim Durchstrahlen einer dünnen Membran. Ion: Schwefel, Membran: Kohlenstoff. [27]

Gleichzeitig können durch den Ionenbeschuss, sowohl auf der Vorder- als auch auf der Rückseite des Filters Sekundärelektronen mit hoher kinetischer Energie erzeugt werden. Bei hohen Stromdichten, wie sie in der industriellen Produktion gefordert werden, wird sich das Energiefilter aufheizen. Aufgrund thermoionischer Elektronenemission (Richardson-Dushman Gesetz) werden abhängig von der Temperatur und der Austrittsarbeit des Filtermaterials thermische Elektronen erzeugt. Dies ist in Figur 37 veranschaulicht, die die Erwärmung eines Energiefilters durch Ionenbeschuss zeigt. Der dargestellten Kurve liegt ein Versuch zugrunde, bei dem ein Filter mit Kohlenstoff-(C)-Ionen mit einer Energie von 6MeV bestrahlt wurde. Das Filter war in diesem Fall ein nicht transparentes Energiefilter [2].

Der Abstand (im Hochvakuum) des Ionenbeschleunigers zwischen Filter und Substrat beträgt typischerweise nur einige Zentimeter oder weniger. D.h. durch Diffusion thermischer Elektronen (aus thermoionischer Emission) und durch Einwirkung schneller Elektronen (aus Ionenbeschuss) wird die Messung des Ionenstroms am Substrat, beispielsweise durch einen dort angebrachten Faraday Cup, verfälscht.

Wie beschrieben, gibt es aus Sicht des Filters Prozesse die Elektronen liefern (Stripping der Primärionen) und es gibt Prozesse die Elektronen emittieren. Somit ist das Potential eines elektrisch isoliert montierten Filters nicht gut definiert, sondern wird in Abhängigkeit von Ionenstrom, Vakuumbedingungen, Temperatur etc. während des Implantationsvorgans variieren. Eine netto-negative Aufladung wird die Emission von Elektronen befördern, eine nettopositive Aufladung wird die Emission von Elektronen tendenziell unterdrücken. Verschiedene Möglichkeiten, eine derartige Aufladung zu verhindern sind nachfolgend erläutert.

### a. Energiefilterelement auf definiertem (positiven) Potential

Es wird vorgeschlagen, den Energiefilter derart auszugestalten und zu montieren, dass das Filter während des Ionenbeschusses immer auf einem definierten Potential liegt. Figur zeigt einen Querschnitt einer Filteranordnung, bei der dies gewährleistet ist. Bei dieser Filteranordnung wird das Filter im Filterrahmen, zum Zwecke der Unterdrückung von Sekundärelektronen, gegenüber dem Filterhalter auf einem definierten (positiven) Potential gehalten wird. Der Filterrahmen ist hierbei an eine Spannungsquelle angeschlossen und gegenüber dem Filterhalter und der Kammerwand des Implanters elektrisch isoliert.

Das elektrische Potential des Filterhalters kann geregelt werden. Beispielsweise derart, dass unabhängig von der Ladungsbilanz, die sich aus dem Implantationsprozess ergibt, während der Implantation ein konstantes Potential gegenüber dem Potential der zu implantierenden Substrate oder dem Erdpotential einstellt. Hierfür kann eine geregelte Zufuhr von positiver oder negativer Ladung durch eine Stromquelle erfolgen.

Das einzustellende Potential kann insbesondere so gewählt werden, dass beispielsweise die Emission von Elektronen aus dem Filter komplett unterdrückt wird und somit im Faraday-Cup neben oder auf dem Substrat nur noch die (positive) Ladung des transmittierten Ionenstroms gemessen wird. Typische Werte für ein solches (positives) Potential liegen zwischen einigen 10V und einigen 1000V.

Für den Fall, dass das Energiefilter aufgrund seiner materiellen Beschaffenheit, sehr hochohmig ist, wird vorgeschlagen den Filter mit einer dünnen hochleitfähigen Schicht mit einer Dicke von einigen Nanometern bis einigen 10 Nanometern ein- oder beidseitig zu belegen. Die Stoppingpower dieser Schicht muss beim Design des Filters mit in die Gesamtbilanz der Stoppingpower aufgenommen werden. Es ist darauf zu achten, dass die aufgebrachte Schicht (auch bei Auftragung auf der dem Substrat abgewandten Seite) prinzipiell keine schädlichen Kontaminationen im zu implantierenden Substratmaterial verursacht. Die Schicht kann für die Bearbeitung von SiC Substraten beispielsweise aus Kohlenstoff bestehen.

### b. Energiefilter wird beschichtet mit Material hoher Austrittsarbeit

Um starke thermoionische Emission zu vermindern, wird vorgeschlagen den Energiefilter mit einem Material mit hoher Elektronenaustrittsarbeit ein- oder beidseitig zu belegen und somit bei gegebener Temperatur eine möglichst geringe thermoionische Emission zu verursachen. Die Austrittsarbeiten einiger Elemente sind in Figur 39 dargestellt. [25] Materials Science-Poland, Vol. 24, No. 4, 2006. Geeignet sind insbesondere Materialien mit einer Austrittarbeit größer als 3,5 eV, größer als 4 eV oder größer als 4,5 eV

Die Stoppingpower dieser Schicht sollte beim Design des Filters mit in die Gesamtbilanz der Stoppingpower aufgenommen werden. Es ist darauf zu achten, dass die aufgebrachte Schicht (auch bei Auftragung auf der dem Substrat abgewandten Seite) prinzipiell keine schädlichen Kontaminationen im zu implantierenden Substratmaterial verursacht.

### Ad 12. Alternative Herstellmethoden durch Spritzguss-, Guss- oder Sinterverfahren

Implantationsfilters können durch mikrotechnische Verfahren hergestellt werden, wie beispielsweise Lithographieverfahren in Kombination mit nasschemischen oder trockenchemischen Ätzverfahren. Insbesondere können für die Filterherstellung anisotrope nasschemische Ätzverfahren mittels alkalischer Ätzmedien (z.B. KOH oder TMAH) in Silizium verwendet werden. Bei derartigen Filtern wird die funktionale Filterschicht aus einkristallinem Silizium hergestellt. Beim Beschuss mit energiereichen Ionen können dadurch Channelingeffekte den effektiven Energieverlust in der Filterschicht in schwer kontrollierbarer Weise beeinflussen. Beispiele, wie solche Effekte vermieden werden können, sind nachfolgend erläutert.
a. Bei einem Beispiel ist vorgesehen, bei Gestaltung des Herstellprozesses als typischer mikrotechnischer Prozess, an Stelle von nasschemischen anisotropen Ätzverfahren, welche einkristallines Material erfordern, auf trockenchemische Ätzprozesse zu setzen und polykristallines oder amorphes Ausgangsmaterial für die Filtermembran zu verwenden. Der resultierende Filter hat strukturell, aufgrund seiner Materialstruktur, hinsichtlich Channeling verbesserte Eigenschaften.
b. Bei einem anderen Beispiel ist vorgesehen, den Filter nicht mit einer typischen mikrotechnischen Prozessabfolge herzustellen, sondern Imprint-, Spritzguss- ,Guss- und Sinterverfahren zum Einsatz zu bringen. Kerngedanke ist es die genannten Prozesse derart anzuwenden, dass eine Form bzw. ein Formeinsatz die finale Form der Energiefiltermembran vorgibt. Das gewählte Filtermaterial wird nun in bekannter Weise für das jeweilige Verfahren verarbeitet d.h. in weichem Zustand (Imprint), flüssigem Zustand (Spritzguss- und Guss) bzw. granularem Zustand (Sinterprozesse) durch die vorgegebene Gussform, den Formeinsatz, den Stempel etc. in die geforderte Geometrie gebracht.

Die Vorteile der Anwendung der genannten Verfahren liegen darin, dass zum einen typischerweise keine einkristallinen Filtermembranen entstehen und somit Channeling unterdrückt wird. Ein weiterer Vorteil liegt darin, dass die zur Verfügung stehende Palette von Filtermembranmaterialien sehr groß ist. Beispielsweise ist die Verwendung von Filtermembranen aus gesintertem SiC für die Erzeugung homogener Dotierprofile in SiC Substraten besonders vorteilhaft.

Ein weitere Vorteil liegt darin, dass durch den Einsatz der genannten abformenden Verfahren, die Kosten für die Herstellung einer großen Anzahl an Filterelementen gegenüber der mikrotechnischen Produktion stark abgesenkt werden können.

### Ad 13. Bestrahlung eines statischen Substrates

Die homogene, energiegefilterte Bestrahlung eines statischen Substrates kann durch Wobbling (= gezieltes Ablenken) des Ionenstrahls vor dem Filter, Anordnung des Filters zwischen Wobbeleinheit (= Ionenstrahlablenksystem) und statischem Substrat und der richtigen Wahl des Ablenkwinkels und des Abstandes d zwischen Filter und Substrat (üblicherweise einige cm bis m) gewährleistet werden, wie in Figur 40 beispielhaft veranschaulicht ist. Figur 40 zeigt eine Anordnung für eine Implantation in ein Substrat durch ein Energiefilter. Diese Anordnung umfasst eine Ablenkeinrichtung für den Ionenstrahl, die vor dem Filter angeordnet ist. Die Ablenkung des Ionenstrahls, die durch diese Ablenkeinrichtung erreicht werden kann, ist so auf den Abstand zwischen Filter und Substrat (typischerweise im Bereich von einigen cm bis einigen m) abgestimmt, dass das Substrat komplett, d.h. auf seiner ganzen Fläche zum Zweck der Implantation bestrahlt werden kann.

### Ad 14. Anordnung zur Ausnutzung einer großen Filterfläche

### a) Anordnung mit komplett aktiver Filterfläche

Figur 41 veranschaulicht eine Anordnung für eine Energiefilter-Implantation (d.h. eine Implantation mittels Energiefilter) gezeigt, bei der die Strahlfläche durch geeignete Maßnahmen vergrößert wurde und die bestrahlte Filterfläche größer ist als die Substratfläche, wodurch eine komplette Bestrahlung des Substrats erreicht werden und eine große Filterfläche genutzt werden kann. Der bestrahlte Filterbereichdurchmesser ist größer als der Substratdurchmesser. Das Substrat kann statisch oder beweglich sein. Durch diese Anordnung wird eine Ausnutzung einer großen Filterfläche (= Verringerung von Degradationseffekten und thermischen Effekten im Filter) und eine komplette Bestrahlung des Substrates gewährleistet. Der Einsatz einer solchen Anordnung ist insbesondere dann vorteilhaft, wenn die benötigten Filterstrukturen "groß" sind. Bei der Dotierung von hochsperrenden Si-IGBTs oder Si-Leistungsdioden mit Protonen werden Eindringtiefen > 100µm benötigt. Für diese Anwendung werden somit Filterstrukturen mit "Zackenhöhen" von > 100µm benötigt. Solche Filterstrukturen können mit ausreichender mechanischer Stabilität sehr einfach, auch für große Substrate (z.B. 6" oder 8") hergestellt werden.

Bei der hier beschriebenen Anordnung sollte ein Mindestabstand zwischen Substrat und Filter eingehalten werden, welcher sicherstellt, dass es durch Streueffekte eine ausreichende laterale Homogenisierung der implantierten Ionen gibt.

### b) Anordnung mit nicht komplett aktiver Filterfläche

Es wird zunächst dieselbe Anordnung wie in 14 a) beschrieben genutzt: Die Anordnung einer Energiefilter-Implantation, bei der die Strahlfläche durch geeignete Maßnahmen vergrößert wurde und die bestrahlte Filterfläche größer ist als die Substratfläche. Allerdings ist hier nicht die gesamte Filterfläche aktiv, sondern nur ein bestimmter Anteil. Dies bedeutet, dass das Filter aus einer Anordnung einer Anzahl von beispielsweise streifenförmigen Filterelementen besteht. Diese Filterelemente können z.B. durch geeignete Herstellprozesse monolithisch aus einem Substrat hergestellt werden. Der andere (nicht aktive) Teil der Filterfläche wird zur Stabilisierung der Filtermembrane genutzt. Dieser Teil schattet den Ionenstrahl ab. Deswegen muss entweder das Substrat oder das Filter bei dieser Anordnung bewegt werden um die Abschattungseffekte auszugleichen. Durch diese Anordnung wird eine Ausnutzung einer großen Filterfläche (= Verringerung von Degradationseffekten und thermischen Effekten im Filter) und eine komplette Bestrahlung des Substrates gewährleistet. Figur 42 veranschaulicht ein teilweise aktives Filter mit mechanischem Scan in eine Richtung.

### Ad 15. Modifizierung des Dotierprofils im Substrat mittels Opferschicht

Außerdem kann eine Opferschicht auf dem Substrat aufgebracht werden, deren Dicke und Stopping Power in geeigneter Art und Weise gewählt ist, sodass das Implantationsprofil in seiner Tiefe im Substrat in gewünschter Weise verschoben wird. Solch eine Opferschicht kann für maskierte Ionenimplantation (vgl. Figur 43) oder auch für unmaskierte Ionenimplantation verwendet werden. Insbesondere kann durch diese Methode ein ungewünschter Anfang eines Dotierprofils aus dem Substrat in die Opferschicht "herausgeschoben" werden, indem der Anfang des Profils in die Opferschicht implantiert wird.

Figur 43 veranschaulicht eine Modifizierung des Dotierprofils im Substrat mittels Opferschicht im Fall einer maskierten, energiegefilterten Implantation. Im hier gezeigten Beispiel wird der Anfang des Implantationsprofils in die Opferschicht geschoben. Dieses Prinzip kann analog für eine unmaskierte, energiegefilterte Ionenimplantation genutzt werden, also eine Implantation bei der anders als in Figur 43 gezeigt keine Maskenschicht vorhanden ist.

### Ad 16. Laterale Modifikation des Dotierprofils im Substrat mittels Opferschicht

Eine Opferschicht wird auf dem Substrat aufgebracht, deren Stopping Power und Verlauf der Dicke über die Waferfläche in geeigneter Art und Weise gewählt ist, sodass das Implantationsprofil in seiner Tiefe im Substrat in Abhängigkeit von der lateralen Position auf dem Wafer in gewünschter Weise verschoben wird. Solch eine Opferschicht kann für maskierte Ionenimplantation oder auch für unmaskierte Ionenimplantation (vgl. Figur 44) verwendet werden. Insbesondere kann die Veränderung der Implantationstiefe eines homogenen Dotierprofiles für Randabschlüsse in Halbleiterbauelementen vorteilhaft eingesetzt werden.

Figur 44 veranschaulicht eine Laterale Modifikation des Dotierprofils im Substrat mittels Opferschicht im Fall einer unmaskierten, energiegefilterten Ionenimplantation. Eine laterale Modifikation der Implantationstiefe kommt hierbei durch eine in lateraler Richtung unterschiedliche Dicke der Opferschicht zustande. Das Prinzip ist analog für maskierte, energiegefilterte Implantationen einsetzbar.

### Ad 17. Anpassung eines Profilübergangs mehrerer Implantationsprofile

Zwei oder mehrere Dotierprofile können in geschickter Weise überlappt werden, sodass ein gewünschtes Gesamtdotierprofil insbesondere im Bereich des Überlapps entsteht. Diese Technik ist insbesondere beim Aufwachsen und dotieren mehrerer Schichten vorteilhaft. Ein repräsentatives Beispiel ist das Aufwachsen mehrerer SiC-Epi-Schichten und jeweiliger energiegefilterter Dotierung. Hier sollte ein guter Kontakt zwischen den Schichten gewährleistet sein.

### Ad 18. Spezielle Anordnung des Multifilterkonzeptes bei gekoppelter Pendelbewegung

Eine geschickte Anordnung kann eingesetzt werden, sodass trotz gekoppelter Pendelbewegung von Filter und Substrat, das heißt keine relative vertikale Bewegung zwischen Filter und Substrat, eine laterale Homogenität der Verteilung der Ionen erreicht wird. Eine solche Anordnung ist in Figur 45 gezeigt. Die Wafer werden durch die Rotation des Waferrades in x-Richtung hinter dem Substrat entlang geführt. Der Ionenstrahl (nicht dargestellt) ist bspw. in x-Richtung aufgeweitet und wird durch die vertikale Pendelbewegung der Implantationskammer über die komplette Multifilterfläche gescannt. Die Fläche besteht aus aktiven Filterbereichen und inaktiven Halterungsbereichen. Anordnung A) ist eine ungünstige Anordnung. Betrachtet man für y1 und y2 die bestrahlte Filterfläche, so werden bei y1 3 Filter bestrahlt während bei y2 gar kein Filter bestrahlt wird. Als Resultat erhält man ein lateral inhomogenes Streifenmuster auf dem Wafer. Anordnung B) zeigt ein mögliches Beispiel einer besseren Anordnung. Sowohl für y1 und y2 werden jeweils 2 Filter bestrahlt. Dies gilt für alle y. Dadurch wird eine lateral homogene Dotierung über die Waferfläche erreicht.

Wie in Figur 45 gezeigt ist, sind die vertikalen Bewegungen in y-Richtung von Filter und Substrat gekoppelt. Die Wafer werden durch die Rotation des Waferrades in x-Richtung hinter dem Substrat entlang geführt. Der Ionenstrahl (nicht dargestellt) ist bspw. in x-Richtung aufgeweitet und wird durch die vertikale Pendelbewegung der Implantationskammer über die komplette Multifilterfläche gescannt. Die Fläche besteht aus aktiven Filterbereichen und inaktiven Halterungsbereichen. Anordnung A) ist eine eher ungünstige Anordnung. Betrachtet man für y1 und y2 die bestrahlte Filterfläche, so werden bei y1 3 Filter bestrahlt während bei y2 gar kein Filter bestrahlt wird. Als Resultat erhält man ein lateral inhomogenes Streifenmuster auf dem Wafer. Anordnung B) zeigt ein mögliches Beispiel einer besseren Anordnung. Sowohl für y1 und y2 werden jeweils 2 Filter bestrahlt. Dies gilt für alle y. Dadurch wird eine lateral homogene Dotierung über die Waferfläche erreicht.

### Ad 19. Monitoring

Ein weiterer Aspekt soll die Aufgabe lösen, wichtige Parameter der durch einen Energiefilter modifizierten Ionenimplantation zu monitoren (überwachen). Solche Parameter sind beispielsweise der minimale oder maximale Projected Range, die durch die Filtergeometrie eingestellte Tiefenkonzentrationsverteilung und die (energieabhängige) Winkelverteilung. Das Monitoring weiterer Parameter, wie implantierte Ionensorte etc., könnte auch sinnvoll sein. Ein Monitoring soll insbesondere auf den zu implantierenden Wafern oder auf (parallel mehreren) Strukturen, die in der Nähe der Wafer angeordnet sind, möglich sein. Gemäß einem Aspekt soll das Monitoring ohne weitere Prozessierung der Monitoringstrukturen oder der Wafer durchgeführt werden.

Das Monitoring kann durch die Messung von optischen Parametern, wie spektrale Absorption, spektrale Transmission, spektrale Reflexion, Änderungen des Brechnungsindex, globale Absorption (Wellenlängenbereich von Messgerät abhängig) und globaler Transmission, sowie Reflexion (Wellenlängenbereich von Messgerät abhängig) durchgeführt werden.

Gemäß einem Aspekt ist vorgesehen, zum Monitoring der genannten Implantationsparameter Anordnungen von Masken und Substratmaterialien zu verwenden, die (1) an geeigneter Stelle auf der zu implantierenden Fläche, z.B. Waferrad, angeordnet sind und (2) durch Ionenimplantation ihre z.B. optischen Eigenschaften "as implanted", d.h. ohne weitere Nachprozessierung so verändern, dass beispielsweise die Änderung proportional zur implantierten Ionendosis für eine gegebene Ionensorte ist. Solche unter (2) genannten Materialien sind beispielsweise PMMA (Plexiglas), PMMA, SiC, LiNbO3, KTiOPO4 o.ä.

Im Falle, dass das in optischer Hinsicht auf Ionenstrahlung sensitive Material gleichzeitig das Material des Zielsubstrates ist, so kann das Zielsubstrat (z.B. ein SiC Wafer) direkt für das optische Monitoring verwendet werden.

Neben Veränderungen der optischen Eigenschaften ist bekannt, dass Materialien wie z.B. PMMA ihre Löslichkeit gegenüber bestimmten Säuren und Lösungsmitteln nach Bestrahlung durch Ionen verändern. Somit kann die Tiefe (oder die Ätzrate oder die resultierende Ätzgeometrie etc.) einer nach Ionenbestrahlung modifizierten Struktur als Maß für die implantierte Ionendosis betrachtet werden.

Das Monitoring über weitere Änderungen von physikalischen Parametern durch Ionenbestrahlung sind denkbar. Solche Änderungen können beispielsweise mechanische Eigenschaften des Monitormaterials, elektrische Eigenschaften des Monitormaterials oder auch die kernphysikalische Aktivierung des Monitormaterials durch hochenergetische Ionenbestrahlung sein.

Gemäß einem Aspekt soll die Detektion über die Änderung optischer Eigenschaften erfolgen. Eine solche Implementierung soll im Folgenden beschrieben werden. Für den häufig auftretenden Fall, dass das Monitoring nicht an den zu implantierenden Zielsubstraten stattfindet, wird die Implementierung von separaten Monitoringstrukturen vorgeschlagen. Eine Monitoringstruktur besteht aus der Anordnung eines geeigneten Substratmaterials mit einer oder mehreren Maskenstrukturen. Beispiele sind in den Figuren 47 und 48 dargestellt.

Die Monitoringstruktur bzw. -strukturen (Monitoringchips) werden, wie in Figur 46 dargestellt an geeigneter Stelle, beispielsweise auf dem Waferwheel, angeordnet. Das Auslesen der Monitoringchips erfolgt nach der Implantation, beispielsweise ohne weitere Nachprozessierung. Ggfs. muss die Maske für die Auslesemessung vom Monitoringsubstrat getrennt werden. Gemäß einem Aspekt ist die Maske wiederverwendbar.

Maskenmaterial und Substratmaterial des Monitoringchips können aus verschiedenen Materialien sein. Das Kritierium für die Auswahl des Maskenmaterials ist beispielsweise die Kompatibilität mit dem Material der Zielsubstrate (um Kontaminationen durch Sputtereffekte auszuschließen) und ein Abbremsvermögen für hochenergetischen Ionen derart, dass Maskenstrukturen mit hohen Aspektverhältnissen hergestellt werden können.

Es ist auch möglich, dass Maskenmaterial und Substratmaterial des Monitoringchips aus dem gleichen Material hergestellt sind. Maske und Substrat können auch monolithisch hergestellt sein. In diesem Fall ist meist weder eine Wiederverwendung der Maske noch des Substrates möglich.

Durchführung und Auswertung der maskierten Struktur nach der Ionenimplantation:
1. Durchführung der energiefiltermodifizierten Ionenimplantation
2. Entfernung der Maske, ggfs. nicht unbedingt notwendig, da die Auslesemessung auch reflektierend von der Rückseite des Substrates erfolgen kann.
3. Optische Messung
   a. Absorptionsspektrum, wellenlängenaufgelöst
   b. Transmissionsspektrum, wellenlängenaufgelöst
   c. Reflektivität, wellenlängenaufgelöst
   d. einfache globale Absorption, d.h. nicht wellenlängenaufgelöst
   e. einfache globale Transmission, d.h. nicht wellenlängenaufgelöst
   f. Messung Änderung des Brechungsindexes
   g. Änderungen der Polarisation
4. Vergleich mit Eichkurve oder Vergleichsstandard und somit Feststellung, ob der Implantprozess wie erwartet abgelaufen ist.

Durch Anwendung der erläuterten Monitoringstrukturen können folgende Implantparameter getestet werden:
A. Tiefenabhängige Dosis,
   somit Test auf Degradation des Filters und Test auf korrekt maschinenseitig eingestellte Implantdosis
B. Maximaler/minimaler Projected Range,
   somit Test auf Anwendung der korrekten Implantenergie; Test auf Degradation des Filters und korrekt hergestellte Filterstrukturen.
C. Winkelverteilung der implantierten Ionen,
   somit Test auf Degradation des Filters, Test auf korrekte Ausbildung des Filters, Test auf korrekte geometrische Anordnung in der Implantationskammer.

### A. Monitoring der Tiefenverteilung der implantierten Ionen

### Ad A. Tiefenabhängige Dosis

In den Figuren 49 bis 52 ist beispielhaft das Monitoring der durch den Energiefilter eingestellten Tiefenverteilung der implantierten Ionendosis erläutert. In diesem Beispiel gelten folgende vereinfachende Annahmen:
- Die Veränderung der optischen Eigenschaften ist nur durch die lokal implantierte Ionendosis und die dadurch verursachten Eigendefekte erzeugt.
- Ionen welche beispielsweise das Tiefengebiet III mit der Ionenkonzentration C1 (Figur 51) nur durchqueren (um in den Konzentrationsbereich C2 zu gelangen) führen zu keiner weiteren Veränderung der optischen Eigenschaften.
- Denkbar wäre, dass genau eine solche Veränderung der optischen Eigenschaften z.B. in PMMA durch elektronisches Abbremsen zu beobachten wäre.
- Dies ist für die prinzipielle Auswertbarkeit kein Problem, soll aber im Beispiel der Figuren 51 und 52 aus Gründen der Vereinfachung ausgeschlossen sein.

Die in Figur 50 gezeigten bzw. beschriebenen Maskenstrukturen sind je nach gewünschter Tiefenauflösung in ihrer Dicke und Anzahl gestaffelt, bzw. als "schiefe Ebene" oder kontinuierliche Rampe ausgeführt. Für die größte Dicke gilt beispielsweise: "Dicke der Maske" > Rp, max.

Die lateralen Abmessungen der Einzelstrukturen, können je nach Erfordernissen der Ausleseapparatur von Quadratmikrometern, über Quadratmillimetern bis hin zu Quadratzentimetern groß sein.

### Ad B. Monitoring des maximalen Proiected Range

In Figur 53 ist eine Struktur dargestellt, welche geeignet ist den maximalen Projected Range zu monitoren.

Analoge Strukturen, unter Anwendung von Auswerteprozeduren wie unter A. beschrieben, auch zur Messung bzw. Überwachung des minimalen Projected Range zur Anwendung kommen.

### Ad C. Monitoring der Winkelverteilung der implantierten Ionen

Es ist bekannt, dass das Energiefilter für Ionenimplantation ein energieabhängiges Spektrum an Ionenwinkeln nach dem Durchgang durch den Filter erzeugt.

Prinzipiell gilt, daß bei senkrechter monoenergetischer Ioneninzidenz auf den Filter nach dem Filter die resultierenden niederenergetischen Ionen stärker gestreut werden, als die hochenergetischen.

Die resultierende Winkelverteilung ist somit eine Funktion der Filtergeometrie, der Veränderung der Geometrie während der Lebensdauer des Filters, dem Auftreten von Channelingeffekten, der eingesetzten Ionensorte, der Primärenergie, der resultierenden Maximal- und Minimalenergie der transmittierten Ionen und der geometrischen Anordnung in der Implantationskammer. Alle diese Parameter können durch das Monitoring der Winkelverteilung überwacht werden.

Für das Monitoring einzelner Parameter werden unterschiedliche Maskenstrukturen, die in einem Monitoringchip angeordnet sein können, vorgeschlagen, wie beispielsweise in den Figuren 55 bis 58 dargestellt bzw. beschrieben ist.

Es ist zu beachten, dass für die Evaluierung der Winkelverteilung häufig nur das Aspektverhältnis der Maskenstruktur ausschlaggebend ist.

Somit können die Öffnungsgrößen der Maskenstrukturen für dünne Masken die nur wenig dicker als der maximale Projected Range im Maskenmaterial sind, im Mikrometer oder Submikrometerbereich liegen.

Solche Monitoringstrukturen werden bevorzugt als Arrays angeordnet, die aus vielen Einzelstrukturen bestehen um eine globale (d.h. auf einer Fläche von mehreren mm² oder cm²) optische Auswertung durchführen zu können.

Im Gegensatz hierzu können bei gleichen Aspektverhältnissen und z.B. Maskendicken im Millimeterbereich, die Öffnungsgrößen im Millimeter- oder Zentimeterbereich liegen. In diesen Fällen ist auch die Auswertung von Einzelstrukturen, die nicht in einem Array angeordnet sind ohne übergroßen technischen Aufwand möglich.

Vorgeschlagene Maskenstrukturen:
1. Feste Maskendicke, Maskenöffnungen verschiedener Geometrie → Variation des Aspektverhältnisses
2. Variable Maskendicke, feste Geometrie der Maskenöffnung → Variation des Aspektverhältnisses
3. Mischungen aus 1 und 2
4. Durch die Anordnung mehrerer Arrays (oder von Einzelstrukturen) aus jeweils 1, 2 oder 3 in zueinander verschiedenen Winkeln kann die Richtungsabhängigkeit der Winkelverteilung überwacht werden.

Kreisförmige Anordnungen sind auch denkbar.

Wie in Figur 58 dargestellt ist, sind neben den ineinander verschachtelten Kreisringen, auch einzelne Kreise und Kreisringe unterschiedlicher Dimensionierung besonders vorteilhaft beim Monitoring der Winkelverteilung der durch den Energiefilter transmittierten Ionen.

Der Kern der zuletzt erläuterten Aspekte besteht darin, die (im wesentlichen) dosisabhängige Modifikation der (bevorzugt) optischen Parameter eines Materials für das "as implanted" Monitoring des Energiefilterimplantationsprozesses anzuwenden. Hierdurch kann durch eine (beispielsweise) optische Messung das resultierende Implantationsergebnis in seinen wichtigsten Parametern möglichst vollständig überwacht werden, ohne dass eine aufwändige Nachprozessierung (z.B. Annealing und Aufbringen von metallischen Kontakten) durchgeführt werden muss.

Es ergibt sich somit die Möglichkeit kostengünstig und schnell Fehlimplantationen erkennen und ggfs. betroffene Wafer aussortieren zu können.

Figur 59 veranschaulicht eine Anpassung eines Profilübergangs zweier Implantationsprofile A und B in geschickter Art und Weise, sodass das resultierende Gesamtkonzentrationsprofil beispielsweise ein gewünschtes homogenes Profil erzeugen kann. Dies kann (muss aber nicht) insbesondere bei Schichtsystemen aus 2 Schichten wie im hier gezeigten Bild vorteilhaft sein. Vorschlag für eine Realisierung mit folgender Prozessreihenfolge: 1) Dotieren der unteren Schicht (Implant B). 2) Aufwachsen der oberen Schicht. 3) Dotieren der oberen Schicht. Bei der Ausgestaltung des hochenergetischen Schwanzes des Implant A bleiben nur begrenzte Möglichkeiten, allerdings kann der niederenergetische Schwanz von Implant B insbesondere durch das Einbringen einer Opferschicht beeinflusst werden, wie sie in "15: Modifizierung des Dotierprofils im Substrat mittels Opferschicht" beschrieben ist. Vorschlag für eine Realisierung mit folgender Prozessreihenfolge: 1) Aufwachsen Opferschicht. 2) Dotieren der unteren Schicht (Implant B). 3) Entfernen der Opferschicht 4) Aufwachsen der oberen Schicht. 5) Dotieren der oberen Schicht.

Die oben erläuterten Konzepte ermöglichen produktionstaugliche Implantationsverfahren für die Halbleiterindustrie, d.h. eine wirtschaftliche Anwendung von Implantationsverfahren in einem industriellen Produktionsprozess. Neben den durch einfache dreiecksförmige Filterstrukturen zu realisierenden homogenen Dotierungen ermöglichen die erläuterten Konzepte insbesondere eine sehr flexible (Multifilterkonzept) Realisierung komplexer vertikaler Dotierkonzentrationsverläufe mit geringer Winkelverteilung der implantierten Ionen. Insbesondere können alle Arten von Dotierkonzentrationsverläufen durch die Verwendung dreiecksförmige Filterstrukturen in Verbindung mit Kollimatorstrukturen approximiert werden. Ein weiterer wichtiger Aspekt betrifft die Unterdrückung von Artefakten, welche die Ionenstrommessung auf dem Substrat verfälschen.

Abschließend sei nochmals daraufhingewiesen, dass die oben unter Ad 1. bis Ad 19. erläuterten Maßnahmen jeweils für sich allein, aber auch in beliebiger Kombination miteinander verwendet werden können. So kann beispielsweise die erläuterte "End-of-Life"-Erkennung auf ein durch einen Rahmen gehaltenes Filter angewendet werden, kann aber auch auf ein anderweitig gehaltenes Filter angewendet werden.

Weiterhin kann der oben erläuterte Wafer ein Halbleiterwafer sein, kann aber auch aus einem anderen zu implantierenden Material bestehen, wie beispielsweise PMMA.

### Referenzen

[0] Energiefilter für Ionenimplantationsanlagen; M.Rüb, Forschungsbericht der Ernst-Abbe-Hochschule Jena 2013/2014
[2] Constantin Csato, Florian Krippendorf, Shavkat Akhmadaliev, Johannes von Borany, Weiqi Han, Thomas Siefke, Andre Zowalla, Michael Rüb, Energy filter for tailoring depth profiles in semiconductor doping application, Nucl. Instr. Meth. B (2015), http://dx.doi.org/10.1016/j.nimb.2015.07.102
[4] Investigation of dopant profiles, losses and heating using an energy filter for ion implantation, Krippendorf, Csato, Rüb, DPG Frühjahrstagung Dresden, March 2014
[5] Energiefilter für Ionenimplantation, F. Krippendorf, C. Csato, T. Bischof, S. Gupta, W. Han, M. Nobst, Ernst-Abbe-Fachhochschule Jena; C. Ronning, Friedrich-Schiller-Universität Jena; R. Rupp, Infineon Technologies AG, Neubiberg; A. Schewior, Ernst-Abbe-Fachhochschule Jena; W. Wesch, Friedrich-Schiller-Universität Jena; W. Morgenroth, Institut für Photonische Technologien e.V., Jena; M. Rüb, Ernst-Abbe-Fachhochschule Jena, Mikrosystemtechnik Kongress, Aachen, Oktober 2014" "Energiefilter für Ionenimplantationsanlagen Idee- erste Experimente - Anwendung, C.
[6] Csato, T. Bischof, S. Gupta, W. Han, F. Krippendorf, W.Morgenroth, M. Nobst, C. Ronning, R. Rupp, A. Schewior, W. Wesch, M. Rüb, 12.06.2013, Workshop "Ionenstrahlen-Forschung und Anwendung" 2013, Leibniz-Institut für Oberflächenmodifizierung Leipzig", M.Rüb, B.Sc. T. Bischof, M.Sc. C. Csato, B.Sc. S. Gupta, B.Sc. W. Han, M.Sc. F. Krippendorf, B.Sc. A. Schewior, B.Sc. C. Möse, Energiefilter für Ionenimplantationsanlagen, Forschungsbericht der Ernst-Abbe-Fachhochschule Jena 2011/2012
[7] EP 8 030 037 A1
[8] Rüb, Energiefilter für Hochenergieionenimplantation, IP.com Disclosure Number: IPCOM000018006D Original Publication Date: 2001-Dec-01 Included in the Prior Art Database: 2003-Jul-23 bzw. Siemens AG, 2001, Siemens Technik Report, Dez. 2001, 9 Seiten.
[9] DE 10 2011 075 350 A1
[10] J.Meijer, B. Burchard, High-energy ion projection for deep ion implantation as a low cost high throughput alternative for subsequent epitaxy processes, J.Vac. Sci. Technol. B22(1)
[11] U.Weber, G. Kraft, Design and construction fo a ripple filter for smoothed depth does distribution in conformal particle therapy, Phys. Med. Biol. 44(1999) 2765-2775
[12] Y.Takada et al., A mininature ripple filter for filtering a ripple found in disatal part of a proton SOBP, Nuclear Instruments and Methods in Physics Research A 524(2004) 366-373
[16] DE19652463 C2
[18] US 7385209 B2
[19] US2002-0050573 A1
[19-1] Energiefilter für Ionenimplantationsanlagen; M.Rüb, Forschungsbericht der Ernst-Abbe-Hochschule Jena 2013/2014
[19-2] DE 102 39 312 B4
[25] Materials Science-Poland, Vol. 24, No. 4, 2006
[26] M. Nastasi et al., Ion-Solid Interactions: Fundamentals and Applications, Cambridge University Press, 1996
[27] O. Osman, Irradiation effects of swift heavy ions in matter, Dissertation, Essen, 2011

## Patentansprüche

1. Implantationsvorrichtung, die aufweist:
einen Filterrahmen; und
ein durch den Filterrahmen gehaltenes Filter, das dazu ausgebildet ist, von einem Ionenstrahl durchstrahlt zu werden, wobei das Filter eine Schichtstruktur mit wenigstens zwei unterschiedlichen Materialschichten aufweist, die in einer Durchstrahlungsrichtung übereinander angeordnet sind.

2. Implantationsvorrichtung nach Anspruch 1, bei der das Filter wenigstens zwei unterschiedlich strukturierte und nebeneinander angeordnete Filterelemente aufweist, wobei die Filterelemente in dem Filterrahmen beabstandet zueinander angeordnet sind.

3. Implantationsvorrichtung nach einem der vorangehenden Ansprüche, die weiterhin aufweist:
eine Kollimatorstruktur, die auf dem Filter angeordnet ist oder im transmittierten Strahl nach dem Filter platziert ist.

4. Implantationsvorrichtung nach Anspruch 3, bei der die Kollimatorstruktur wenigstens eine Röhre mit einer Länge und einer Breite aufweist, wobei ein Verhältnis von Breite zu Länge kleiner als 1, kleiner als 2, kleiner als 5 oder kleiner als 10 ist.

5. Implantationsvorrichtung nach einem der vorangehenden Ansprüche, die weiterhin aufweist:
einen elektronisch auslesbaren Speicher mit einer in dem Speicher abgespeicherten Information über das Filter.

6. Implantationsvorrichtung nach Anspruch 5, bei der die Information wenigstens eine der folgenden aufweist:
eine Signatur;
eine maximal zulässige Temperatur des Filters; und
eine maximal zulässige Durchstrahlungsdosis.

7. Implantationsanlage, die aufweist:
eine Wand mit einer Öffnung;
ein an der Wand im Bereich der Öffnung angeordneter Filterhalter mit einer Aufnahme, die dazu ausgebildet ist, einen Filterrahmen aufzunehmen, und mit einer Implantationsvorrichtung nach einem der Ansprüche 1 bis 6, deren Filterrahmen in den Filterhalter eingesetzt ist.

8. Implantationsanlage nach Anspruch 7, bei der der Filterhalter eine in dem Filterhalter integrierte oder an dem Filterhalter angeordnete Kühlvorrichtung aufweist.

9. Implantationsanlage nach Anspruch 8, bei der die Kühlvorrichtung wenigstens eine Kühlmittelleitung aufweist.

10. Implantationsanlage nach einem der Ansprüche 7 bis 9, die weiterhin aufweist:
ein vor der Öffnung angeordnetes Ionenstrahlablenksystem.

11. Implantationsanlage nach einem der Ansprüche 7 bis 10, bei der der Filterhalter dazu ausgebildet ist, den Filterrahmen berührungslos aufzunehmen, wobei der Filterhalter wenigstens einen Magneten zur Halterung des Filterrahmens aufweist.

12. Verfahren, das aufweist:
Implantieren von Ionen in einen Wafer durch Bestrahlen des Wafers mit einem Ionenstrahl über eine Implantationsvorrichtung nach einem der Ansprüche 1 bis 6.

13. Verfahren nach Anspruch 12, bei dem das Filter wenigstens eine ebene Fläche aufweist und bei dem das Filter so gegenüber dem Ionenstrahl ausgerichtet ist, dass eine Strahlrichtung des Ionenstrahls gegenüber der ebenen Fläche geneigt ist.

14. Verfahren nach Anspruch 12 oder 13, bei dem eine Filterfläche größer als eine Fläche des Wafers ist.

15. Verfahren nach einem der Ansprüche 12 bis 14, das weiterhin aufweist:
Anordnen einer Monitoringstruktur in der Nähe des Wafers und Implantieren in die Monitoringstruktur.

## Claims

1. Implantation device comprising:
a filter frame; and
a filter held by the filter frame, said filter being configured to be irradiated by an ion beam passing through it, wherein the filter comprises a layer structure having at least two different material layers arranged one above another in a direction of radiation transmission.

2. Implantation device according to Claim 1, wherein the filter comprises at least two differently structured filter elements arranged next to one another, wherein the filter elements are arranged at a distance from one another in the filter frame.

3. Implantation device according to either of the preceding claims, furthermore comprising:
a collimator structure arranged on the filter or positioned in the transmitted beam downstream of the filter.

4. Implantation device according to Claim 3, wherein the collimator structure comprises at least one tube having a length and a width, wherein a ratio of width to length is less than 1, less than 2, less than 5 or less than 10.

5. Implantation device according to any of the preceding claims, furthermore comprising:
an electronically readable memory with information about the filter stored in the memory.

6. Implantation device according to Claim 5, wherein the information comprises at least one of the following:
a signature;
a maximum permissible temperature of the filter; and
a maximum permissible irradiation dose.

7. Implantation system comprising:
a wall having an opening;
a filter holder arranged on the wall in the region of the opening and having a receptacle configured to receive a filter frame, and having an implantation device according to any of Claims 1 to 6, the filter frame of which is inserted into the filter holder.

8. Implantation system according to Claim 7, wherein the filter holder comprises a cooling device integrated in the filter holder or arranged on the filter holder.

9. Implantation system according to Claim 8, wherein the cooling device comprises at least one coolant line.

10. Implantation system according to any of Claims 7 to 9, furthermore comprising:
an ion beam deflection system arranged upstream of the opening.

11. Implantation system according to any of Claims 7 to 10, wherein the filter holder is configured to receive the filter frame in a non-contact manner, wherein the filter holder comprises at least one magnet for holding the filter frame.

12. Method comprising:
implanting ions into a wafer by irradiating the wafer with an ion beam by way of an implantation device according to any of Claims 1 to 6.

13. Method according to Claim 12, wherein the filter comprises at least one planar surface, and wherein the filter is oriented relative to the ion beam in such a way that a beam direction of the ion beam is inclined relative to the planar surface.

14. Method according to Claim 12 or 13, wherein a surface area of the filter is greater than a surface area of the wafer.

15. Method according to any of Claims 12 to 14, furthermore comprising:
arranging a monitoring structure in the vicinity of the wafer and carrying out implantation into the monitoring structure.

## Revendications

1. Dispositif d'implantation, lequel comprend :
un cadre de filtre ; et
un filtre maintenu par le cadre de filtre et conçu pour être irradié par un faisceau ionique, le filtre comportant une structure de couches pourvue d'au moins deux couches de matériau différentes qui sont disposées l'une au-dessus de l'autre dans une direction d'irradiation.

2. Dispositif d'implantation selon la revendication 1, le filtre comportant au moins deux éléments filtrants qui présentent des structures différentes et qui sont disposés côte à côte, les éléments filtrants étant disposés dans le cadre de filtre à distance l'un de l'autre.

3. Dispositif d'implantation selon l'une des revendications précédentes, lequel comprend en outre :
une structure formant collimateur qui est disposée sur le filtre ou qui est placée après le filtre dans le faisceau transmis.

4. Dispositif d'implantation selon la revendication 3, dans lequel la structure formant collimateur comporte au moins un tube pourvu d'une longueur et d'une largeur, un rapport de la largeur à la longueur étant inférieur à 1, inférieur à 2, inférieur à 5 ou inférieur à 10.

5. Dispositif d'implantation selon l'une des revendications précédentes, lequel comprend en outre :
une mémoire lisible électroniquement comportant une information sur le filtre stockée dans la mémoire.

6. Dispositif d'implantation selon la revendication 5, dans lequel l'information inclut l'un au moins des éléments suivants :
une signature ;
une température maximale admissible du filtre ; et
une dose de rayonnement maximale admissible.

7. Système d'implantation, lequel comprend :
une paroi pourvue d'une ouverture ;
un porte-filtre disposé sur la paroi dans la région de l'ouverture et comportant un réceptacle, conçu pour recevoir un cadre de filtre, et un dispositif d'implantation selon l'une des revendications 1 à 6, dont le cadre de filtre est inséré dans le porte-filtre.

8. Système d'implantation selon la revendication 7, dans lequel le porte-filtre comporte un dispositif de refroidissement intégré dans le porte-filtre ou disposé sur le porte-filtre.

9. Système d'implantation selon la revendication 8, dans lequel le dispositif de refroidissement comporte au moins une conduite de liquide de refroidissement.

10. Système d'implantation selon l'une des revendications 7 à 9, comprenant en outre :
un système de déflexion de faisceau ionique disposé devant l'ouverture.

11. Système d'implantation selon l'une des revendications 7 à 10, dans lequel le porte-filtre est conçu pour recevoir le cadre de filtre sans contact, le porte-filtre comportant au moins un aimant destiné à maintenir le cadre de filtre.

12. Procédé, lequel comprend l'étape suivante :
implanter des ions dans une plaquette par irradiation de la plaquette avec un faisceau ionique par le biais d'un dispositif d'implantation selon l'une des revendications 1 à 6.

13. Procédé selon la revendication 12, dans lequel le filtre comporte au moins une surface plane et dans lequel le filtre est orienté par rapport au faisceau ionique de telle sorte qu'une direction du faisceau ionique est inclinée par rapport à la surface plane.

14. Procédé selon la revendication 12 ou 13, dans lequel la surface de filtre est plus grande que la surface de la plaquette.

15. Procédé selon l'une des revendications 12 à 14, comprenant en outre l'étape suivante :
disposer une structure de contrôle au voisinage de la plaquette et effectuer une implantation dans la structure de contrôle.
